# EUROPEAN PATENT SPECIFICATION

(11) **EP 3 135 405 B1**
(45) Date of publication and mention of the grant of the patent: **20.07.2022**
(21) Application number: 15782582.9
(22) Date of filing: 24.03.2015
(51) Int. Cl.: C09C 1/62, H01B 1/22, C09D 11/037, C09D 11/101, C09D 11/52, B22F 1/052, B22F 1/0545, B22F 1/102, C09D 5/24, B22F 9/30, B22F 9/24, H05K 1/09

(54) **SILVER PARTICLE COATING COMPOSITION**
SILBERPARTIKELBESCHICHTUNGSZUSAMMENSETZUNG
COMPOSITION DE REVETEMENT DE PARTICULES D'ARGENT

(30) Priority: 25.04.2014 JP 2014091216
(43) Date of publication of application: 01.03.2017
(73) Proprietor: Daicel Corporation, Osaka-shi, Osaka 530-0011 (JP)
(72) Inventor: KODUMA, Hiroyoshi, Himeji-shi Hyogo 671-1283 (JP)
(74) Representative: Grünecker Patent- und Rechtsanwälte PartG mbB
(86) International application number: PCT/JP2015/059000
(87) International publication number: WO 2015/163076

(56) References cited:
- WO-A1-2013/105530
- WO-A1-2013/108408
- JP-A- 2005 111 665
- JP-A- 2005 174 828
- JP-A- 2006 257 517
- JP-A- 2008 091 250
- JP-A- 2010 037 574
- JP-A- 2013 036 057
- JP-A- 2013 142 172
- JP-A- 2013 142 173
- JP-A- 2014 034 690
- US-A1- 2005 207 930

## Description

### TECHNICAL FIELD

The present invention relates to a silver particle-containing coating composition. The silver particle coating composition according to the present invention is suitable for intaglio offset printing.

### BACKGROUND ART

Silver nano-particles can be sintered even at a low temperature. Utilizing this property, a silver coating composition containing silver nano-particles is used to form electrodes or conductive circuit patterns on a substrate in production of various electronic devices. Silver nano-particles are usually dispersed in an organic solvent. Silver nano-particles have an average primary particle diameter of about several nanometers to about several tens of nanometers, and their surfaces are usually coated with an organic stabilizer (protective agent). When the substrate is a plastic film or sheet, silver nano-particles need to be sintered at a low temperature (e.g., at 200°C or less) less than a heat resistant temperature of the plastic substrate.

Particularly, attempts have been recently made to form fine metal lines (e.g., silver lines) not only on heat-resistant polyimide substrates that are already in use as substrates for flexible printed circuit boards but also on substrates made of various plastics, such as PET (polyethylene terephthalate) and polypropylene, that have lower heat resistance than polyimide but can be easily processed and are cheap. When plastic substrates having low heat resistance are used, metal nano-particles (e.g., silver nano-particles) need to be sintered at a lower temperature.

For example, JP-A-2008-214695 discloses a method for producing silver ultrafine particles, comprising reacting silver oxalate and oleylamine to form a complex compound containing at least silver, oleylamine, and an oxalate ion; and thermally decomposing the formed complex compound to form silver ultrafine particles (claim 1). Further, JP-A-2008-214695 discloses that in the above method, a saturated aliphatic amine having 1 to 18 carbon atoms in total is reacted in addition to the silver oxalate and the oleylamine (claims 2 and 3), so that a complex compound can be easily formed, the time required to produce silver ultrafine particles can be reduced, and the silver ultrafine particles protected by these amines can be formed in higher yield (paragraph [0011]).

JP-A-2010-265543 discloses a method for producing coated silver ultrafine particles, comprising the first step of mixing a silver compound that is decomposed by heating to generate metallic silver, a mid- to short-chain alkylamine having a boiling point of 100°C to 250°C, and a mid- to short-chain alkyldiamine having a boiling point of 100°C to 250°C to prepare a complex compound containing the silver compound, the alkylamine, and the alkyldiamine; and the second step of thermally decomposing the complex compound (claim 3, paragraphs [0061] and [0062]).

JP-A-2012-162767 discloses a manufacturing method of coated metal fine particles, comprising a first step of mixing an amine liquid mixture of an alkylamine having 6 or more carbon atoms and an alkylamine having 5 or less carbon atoms with a metal compound including a metal atom, thereby generating a complex compound including the metal compound and amines; and a second step of heating and decomposing the complex compound, thereby generating metal fine particles (claim 1) JP-A-2012-162767 also discloses that coated silver fine particles can be dispersed in an organic solvent, such as an alcohol solvent such as butanol, a non-polar solvent such as octane, or a solvent mixture thereof (paragraph [0079]).

JP-A-2013-142172 discloses a method for producing silver nano-particles comprising:
preparing an amine mixture liquid comprising:
an aliphatic hydrocarbon monoamine (A) comprising an aliphatic hydrocarbon group and one amino group, said aliphatic hydrocarbon group having 6 or more carbon atoms in total;
an aliphatic hydrocarbon monoamine (B) comprising an aliphatic hydrocarbon group and one amino group, said aliphatic hydrocarbon group having 5 or less carbon atoms in total; and
an aliphatic hydrocarbon diamine (C) comprising an aliphatic hydrocarbon group and two amino groups, said aliphatic hydrocarbon group having 8 or less carbon atoms in total;
mixing a silver compound and the amine mixture liquid to form a complex compound comprising the silver compound and the amines; and
thermally decomposing the complex compound by heating to form silver nano-particles (claim 1). JP-A-2013-142172 also discloses that a silver coating composition called "silver ink" can be prepared by dispersing the obtained silver nano-particles in suspension state in an appropriate organic solvent (dispersion medium). JP-A-2013-142172 discloses, as the organic solvent, aliphatic hydrocarbon solvents such as pentane, hexane, heptane, octane, nonane, decane, undecane, dodecane, tridecane, and tetradecane; aromatic hydrocarbon solvents such as toluene, xylene, and mesitylene; and alcohol solvents such as methanol, ethanol, propanol, n-butanol, n-pentanol, n-hexanol, n-heptanol, n-octanol, n-nonanol, and n-decanol (paragraph [0085]).

JP-A-2013-142173 discloses a method for producing silver nano-particles comprising
preparing an amine mixture liquid comprising:
an aliphatic hydrocarbon monoamine (A) comprising an aliphatic hydrocarbon group and one amino group, said aliphatic hydrocarbon group having 6 or more carbon atoms in total; and
an aliphatic hydrocarbon monoamine (B) comprising an aliphatic hydrocarbon group and one amino group, said aliphatic hydrocarbon group having 5 or less carbon atoms in total, in a specific ratio;
mixing a silver compound and the amine mixture liquid to form a complex compound comprising the silver compound and the amines; and
thermally decomposing the complex compound by heating to form silver nano-particles (claim 1). In the same way as JP-A-2013-142172, JP-A-2013-142173 also discloses that a silver coating composition called "silver ink" can be prepared by dispersing the obtained silver nano-particles in suspension state in an appropriate organic solvent (dispersion medium), and discloses the same organic solvents as in JP-A-2013-142172 (paragraph [0076]).

WO 2014/024721 discloses a method for producing silver nano-particles comprising:
mixing a silver compound with an aliphatic amine comprising at least a branched aliphatic hydrocarbon monoamine (D) comprising a branched aliphatic hydrocarbon group and one amino group, said branched aliphatic hydrocarbon group having 4 or more carbon atoms, to form a complex compound comprising the silver compound and the amine; and
thermally decomposing the complex compound by heating to form silver nano-particles (claim 1).

JP-A-2010-55807 discloses a conductive paste for use in intaglio offset printing using a silicone blanket made of silicone rubber, comprising a binder resin, a conductive powder, and a mixed solvent of a high-swellable solvent and a low-swellable solvent (claim 1). A silver powder is mentioned as the conductive powder (paragraph [0033]). JP-A-2010-55807 discloses that the conductive powder preferably has a particle diameter at 50% of cumulative particle size distribution D₅₀ of 0.05 µm or more and 10 µm or less, particularly preferably 0.1 µm or more and 2 µm or less, and that a scale-like conductive powder and a spherical conductive powder are preferably used in combination (paragraph [0034]). JP-A-2010-55807 does not disclose silver nano-particles whose surfaces are coated with a protective agent containing an aliphatic hydrocarbon amine. JP-A-2010-55807 does not disclose conductive performance, either.

JP-A-2010-90211 discloses a conductive ink composition comprising conductive particles, and an organic vehicle comprising a resin composition and a solvent (claim 1), and discloses that the conductive particles are Ag particles (claim 10). The conductive ink composition is used for forming an electrode by intaglio offset printing (paragraph [0001]). JP-A-2010-90211 discloses that the conductive particles comprise spherical conductive particles having an average particle diameter of 0.05 µm to 3 µm and flaky conductive particles having an average flake diameter of 0.1 µm or more and less than 3 µm (paragraph [0014]). JP-A-2010-90211 does not disclose silver nano-particles whose surfaces are coated with a protective agent containing an aliphatic hydrocarbon amine. JP-A-2010-90211does not describe calcining conditions in examples (e.g., paragraph [0027]), and does not disclose conductive performance by low-temperature calcining, either.

JP-A-2011-37999 discloses a conductive ink comprising a conductive powder, a resin that is solid at 25°C, a monomer component selected from an oxetane-based monomer, an epoxy-based monomer, and a vinyl ether-based monomer, a polymerization initiator, and a specific organic solvent, the conductive ink having a viscosity at 25°C of 3 to 30 Pa•s (claim 1). JP-A-2011-37999 discloses that the conductive powder is a combination of a spherical silver powder having an average particle diameter of 1 µm or less and a spherical silver powder having an average particle diameter of 1 µm or more and 3 µm or less (paragraph [0017]). However, when the conductive ink disclosed in JP-A-2011-37999 is calcined at a low temperature (120°C), satisfactory conductive performance cannot be achieved (paragraph [0054], Table 2). JP-A-2011-37999 does not disclose silver nano-particles whose surfaces are coated with a protective agent containing an aliphatic hydrocarbon amine.

JP-A-2012-38615 discloses a conductive silver paste comprising silver particles, a resin that is solid at 25°C, and an organic cyclic ether compound (bifunctional oxetane compound), the conductive silver paste having a viscosity at 25°C of 3 to 30 Pa•s (claims 1, 2, and 3). JP-A-2012-38615 also discloses that silver particles having a median size (D50) of 1.0 to 10.0 µm and silver particles having a median size (D50) of 0.2 to 0.9 µm are used in combination as the silver particles so that an amount of the silver particles having a median size of 0.2 to 0.9 µm is 50 to 200 parts by mass per 100 parts by mass of the silver particles having a median size of 1.0 to 10.0 µm (claim 6, paragraph [0012]). However, when the conductive silver paste disclosed in JP-A-2012-38615 is calcined at a low temperature (140°C), satisfactory conductive performance cannot be achieved (paragraph [0046], Table 1). JP-A-2012-38615 does not disclose silver nano-particles whose surfaces are coated with a protective agent containing an aliphatic hydrocarbon amine. JP 2008 091250 discloses (example 1) a silver particle coating composition comprising: silver nano-particles (4.5g, the example discloses 6g and 75:25 Ag nanoparticle: organic protective coating) whose surfaces are coated with a protective agent containing an aliphatic hydrocarbon amine (octylamine); silver microparticles (6g); and a dispersion solvent (decanol), wherein the amount of the silver nano-particles (N) is 43 wt%, based on the total amount of the silver nano-particles (N) and the silver microparticles (M), and wherein the total amount of the silver nano-particles (N) and the silver microparticles (M) is 88 %by weight in the silver particle coating composition.

### PRIOR ART DOCUMENTS

### PATENT DOCUMENTS

Patent Document 1: JP-A-2008-214695
Patent Document 2: JP-A-2010-265543
Patent Document 3: JP-A-2012-162767
Patent Document 4: JP-A-2013-142172
Patent Document 5: JP-A-2013-142173
Patent Document 6: WO 2014/024721
Patent Document 7: JP-A-2010-55807
Patent Document 8: JP-A-2010-90211
Patent Document 9: JP-A-2011-37999
Patent Document 10: JP-A-2012-38615

### SUMMARY OF THE INVENTION

### PROBLEMS TO BE SOLVED BY THE INVENTION

Silver nano-particles have an average primary particle diameter of about several nanometers to about several tens of nanometers, and are more likely to agglomerate than micron (µm)-size particles. Therefore, the reduction reaction of a silver compound (thermal decomposition reaction in the above Patent Documents 1 to 6) is performed in the presence of an organic stabilizer (protective agent such as an aliphatic amine or an aliphatic carboxylic acid) so that the surfaces of resulting silver nano-particles are coated with the organic stabilizer.

Meanwhile, silver nano-particles are used in a silver coating composition (silver ink or silver paste) in which the particles are contained in an organic solvent. In order to develop conductivity, an organic stabilizer coating the silver nano-particles needs to be removed during calcining performed after application of the silver coating composition onto a substrate to sinter the silver particles. When the temperature of the calcining is low, the organic stabilizer is poorly removed. When the silver particles are not sufficiently sintered, a low resistance value cannot be achieved. That is, the organic stabilizer present on the surfaces of the silver nano-particles contributes to the stabilization of the silver nano-particles, but on the other hand, interferes with the sintering of the silver nano-particles (especially, sintering by low-temperature calcining).

The use of an aliphatic amine compound and/or an aliphatic carboxylic acid compound each having a relatively long chain (e.g., 8 or more carbon atoms) as an organic stabilizer makes it easy to stabilize silver nano-particles because it is easy to ensure space between the silver nano-particles . On the other hand, the long-chain aliphatic amine compound and/or the long-chain aliphatic carboxylic acid compound are/is poorly removed when the temperature of calcining is low.

As described above, the relationship between the stabilization of silver nano-particles and the development of a low resistance value by low-temperature calcining is a trade-off.

The above Patent Documents 7 to 10 do not disclose silver nano-particles whose surfaces are coated with a protective agent containing an aliphatic hydrocarbon amine, and do not disclose the matter that satisfactory conductive performance is achieved by low-temperature calcining, either.

It is therefore an object of the present invention to provide a silver particle coating composition that develops excellent conductivity (low resistance value) by low-temperature and short-time calcining.

Further, a silver coating film (calcined silver film) obtained by calcining the silver particle coating composition applied (or printed) onto a substrate on which the silver particle coating composition should be printed is also required to have excellent adhesion to the substrate.

It is therefore an object of the present invention to provide a silver particle coating composition that develops excellent conductivity (low resistance value) by low-temperature and short-time calcining, and that achieves excellent adhesion between a silver coating film (calcined silver film) and a substrate.

Meanwhile, when the silver particle coating composition is used for intaglio offset printing, the silver particle coating composition needs to have improved transferability from a blanket to a substrate on which the silver particle coating composition should be printed. In intaglio offset printing, recesses of an intaglio plate are first filled with the silver coating composition, the silver coating composition filled in the recesses is transferred to allow a blanket (usually made of silicone rubber) to receive the silver coating composition, and then the silver coating composition is transferred from the blanket to a substrate on which the silver coating composition should be printed. At this time, the blanket absorbs a solvent of the silver coating composition to some extent and therefore swells, which reduces adhesion between the silver coating composition and the surface of the blanket. This improves transferability from the blanket to the substrate.

It is therefore an object of the present invention to provide a silver coating composition that develops excellent conductivity (low resistance value) by low-temperature and short-time calcining, and that is suitable for intaglio offset printing.

### MEANS FOR SOLVING THE PROBLEMS

The present inventor has completed the present invention by using silver nano-particles which are prepared by a so-called thermal decomposition method and whose surfaces are coated with a protective agent containing an aliphatic hydrocarbon amine, and silver microparticles. The present invention is defined in the appended claims.

### EFFECTS OF THE INVENTION

The silver particle coating composition according to the present invention comprises silver nano-particles (N) whose surfaces are coated with a protective agent containing an aliphatic hydrocarbon amine, and silver microparticles (M). In a coating layer of the silver particle coating composition onto a substrate, the silver nano-particles (N) penetrate into gaps among the silver microparticles (M). This improves the contact efficiency between the silver nano-particles (N) and the silver microparticles (M) so that conductivity is improved by calcining.

The silver nano-particles (N) whose surfaces are coated with a protective agent containing an aliphatic hydrocarbon amine are prepared by so-called thermal decomposition of a silver complex compound. In the present invention, when an aliphatic hydrocarbon monoamine (A) having 6 or more carbon atoms in total, and at least one of an aliphatic hydrocarbon monoamine (B) having 5 or less carbon atoms in total and an aliphatic hydrocarbon diamine (C) having 8 or less carbon atoms in total are used, as aliphatic hydrocarbon amine compounds that function as a complex-forming agent and/or a protective agent, silver nano-particles whose surfaces are coated with these aliphatic amine compounds are formed.

The aliphatic hydrocarbon monoamine (B) and the aliphatic hydrocarbon diamine (C) each have a short carbon chain, and are therefore easily removed from the surfaces of the silver particles in a short time of 2 hours or less, for example, 1 hour or less, preferably 30 minutes or less even by low-temperature calcining at a temperature of 200°C or less, for example, 150°C or less, preferably 120°C or less. In addition, the presence of the monoamine (B) and/or the diamine (C) reduces the amount of the aliphatic hydrocarbon monoamine (A) adhered to the surfaces of the silver particles. This makes it possible to easily remove these aliphatic amine compounds from the surfaces of the silver particles in such a short time as described above even by low-temperature calcining at such a low temperature as described above, thereby allowing the silver particles to be sufficiently sintered.

As described above, according to the present invention, it is possible to provide a silver particle coating composition (silver particle-containing ink, or silver particle-containing paste) that is excellent in contact efficiency between silver nano-particles (N) and silver microparticles (M), and develops excellent conductivity (low resistance value) by low-temperature and short-time calcining.

When the silver particle coating composition further comprises a binder resin, a silver coating film (calcined silver film) obtained by calcining the silver particle coating composition applied (or printed) onto a substrate on which the silver particle coating composition should be printed has excellent adhesion to the substrate.

When the silver particle coating composition further comprises a curable monomer and a polymerization initiator, adhesion between the silver coating film (calcined silver film) and the substrate is further improved, and flexibility of the silver coating film (calcined silver film) is improved. This improves followability of the calcined silver film to a flexible substrate such as a plastic substrate.

As described above, according to the present invention, it is possible to provide a silver particle coating composition that develops excellent conductivity (low resistance value) by low-temperature and short-time calcining, achieves excellent adhesion between a silver coating film (calcined silver film) and a substrate, and further achieves excellent flexibility of a silver coating film (calcined silver film).

When the silver particle coating composition according to the present invention is used for intaglio offset printing in a state where the silver nano-particles (N) and the silver microparticles (M) are dispersed in a dispersion solvent containing a glycol ester-based solvent, such a dispersion solvent improves the transferability of the silver ink from a blanket to a substrate. In intaglio offset printing, recesses of an intaglio plate are first filled with the silver coating composition, the silver coating composition filled in the recesses is transferred to allow a blanket (usually made of silicone rubber) to receive the silver coating composition, and then the silver coating composition is transferred from the blanket to a substrate. At this time, the blanket absorbs the solvent of the silver coating composition to some extent and therefore swells. This is considered to reduce adhesion between the silver coating composition and the surface of the blanket, and improve transferability from the blanket to the substrate.

As described above, according to the present invention, it is possible to provide a silver coating composition that develops excellent conductivity (low resistance value) by low-temperature and short-time calcining, and is suitable for intaglio offset printing.

According to the present invention, it is possible to form a conductive film or a conductive line even on any plastic substrate having low heat resistance such as a PET substrate or a polypropylene substrate, preferably by intaglio offset printing. The silver particle coating composition according to the present invention is suitable for use in elements in recent various electronic devices.

### MODES FOR CARRYING OUT THE INVENTION

A silver particle coating composition according to the present invention is defined in the appended claims.

### [Silver nano-particles (N) whose surfaces are coated with aliphatic hydrocarbon amine protective agent]

The silver nano-particles (N) may be produced by
mixing an aliphatic hydrocarbon amine and a silver compound to form a complex compound comprising the silver compound and the amine; and
thermally decomposing the complex compound by heating. Therefore, a method for producing silver nano-particles (N) mainly includes a complex compound-forming step, and a thermal decomposition step of the complex compound. The obtained silver nano-particles (N) are subjected to a dispersion step for producing a coating composition.

In this description, the term "nano-particles" means that primary particles have a size (average primary particle diameter), which is measured by observation result with a scanning electron microscope (SEM), of less than 1,000 nm. The particle size refers to the size of a particle not including a protective agent (stabilizer) present on (coating) the surface of the particle (i.e., refers to the size of silver itself). In the present invention, the silver nano-particles have an average primary particle diameter of, for example, 0.5 nm to 100 nm, preferably 0.5 nm to 80 nm, more preferably 1 nm to 70 nm, even more preferably 1 nm to 60 nm.

The above-mentioned silver compound used in the present invention is one that is easily decomposed by heating to generate metallic silver. Examples of such a silver compound that can be used include: silver carboxylates such as silver formate, silver acetate, silver oxalate, silver malonate, silver benzoate, and silver phthalate; silver halides such as silver fluoride, silver chloride, silver bromide, and silver iodide; silver sulfate, silver nitrate, silver carbonate, and the like. In terms of the fact that metallic silver is easily generated by decomposition and impurities other than silver are less likely to be generated, silver oxalate is preferably used. Silver oxalate is advantageous in that silver oxalate has a high silver content, and metallic silver is directly obtained by thermal decomposition without the need for a reducing agent, and therefore impurities derived from a reducing agent are less likely to remain.

Further, in order to obtain a composite with silver, the above-mentioned silver compound and another metal other than silver may be used in combination. Examples of another metal include Al, Au, Pt, Pd, Cu, Co, Cr, In, and Ni. The silver composite is composed of silver and one or more other metals, and examples thereof include Au-Ag, Ag-Cu, Au-Ag-Cu, Au-Ag-Pd, and the like. The amount of silver occupies at least 20% by weight, usually at least 50% by weight, for example, at least 80% by weight of the total amount of the metals.

In the present invention, in the complex compound-forming step, an aliphatic hydrocarbon amine and a silver compound may be mixed in the absence of a solvent, but are preferably mixed in the presence of an alcohol solvent having 3 or more carbon atoms to form a complex compound comprising the silver compound and the amine.

As the alcohol solvent, an alcohol having 3 to 10 carbon atoms, preferably an alcohol having 4 to 6 carbon atoms can be used. Examples of such an alcohol include n-propanol (boiling point (bp) : 97°C), isopropanol (bp: 82°C), n-butanol (bp: 117°C), isobutanol (bp: 107.89°C), sec-butanol (bp: 99.5°C), tert-butanol (bp: 82.45°C), n-pentanol (bp: 136°C), n-hexanol (bp: 156°C), n-octanol (bp: 194°C), 2-octanol (bp: 174°C), and the like. Among them, butanols selected from n-butanol, isobutanol, sec-butanol and tert-butanol, and hexanols are preferred in consideration of the fact that the temperature of the thermal decomposition step of the complex compound subsequently performed can be increased, and post-treatment after the formation of silver nano-particles is easy. Particularly, n-butanol and n-hexanol are preferred.

In order to sufficiently stir a silver compound-alcohol slurry, the alcohol solvent is used in an amount of, for example, 120 parts by weight or more, preferably 130 parts by weight or more, more preferably 150 parts by weight or more with respect to 100 parts by weight of the silver compound. The upper limit of the amount of the alcohol-based solvent is not particularly limited, and is, for example, 1,000 parts by weight or less, preferably 800 parts by weight or less, more preferably 500 parts by weight or less with respect to 100 parts by weight of the silver compound.

In the present invention, the mixing of an aliphatic hydrocarbon amine and a silver compound in the presence of an alcohol solvent having 3 or more carbon atoms can be performed in several ways.

For example, the mixing may be performed by first mixing a solid silver compound and an alcohol solvent to obtain a silver compound-alcohol slurry [slurry-forming step], and then by adding an aliphatic hydrocarbon amine to the obtained silver compound-alcohol slurry. The slurry represents a mixture in which the solid silver compound is dispersed in the alcohol solvent. The slurry may be obtained by adding the alcohol solvent to the solid silver compound contained in a reaction container.

Alternatively, the silver compound-alcohol slurry may be added to the aliphatic hydrocarbon amine and the alcohol solvent contained in a reaction container.

In the present invention, as an aliphatic hydrocarbon amine that functions as a complex-forming agent and/or a protective agent, for example, one may be used, which contains an aliphatic hydrocarbon monoamine (A) having a hydrocarbon group having 6 or more carbon atoms in total, and further contains at least one of an aliphatic hydrocarbon monoamine (B) comprising an aliphatic hydrocarbon group and one amino group, said aliphatic hydrocarbon group having 5 or less carbon atoms in total; and an aliphatic hydrocarbon diamine (C) comprising an aliphatic hydrocarbon group and two amino groups, said aliphatic hydrocarbon group having 8 or less carbon atoms in total. These respective components are usually used in the form of an amine mixture liquid, but mixing of the amines with the silver compound (or alcohol slurry thereof) does not always need to be performed using a mixture of the amines. These amines may be added one by one to the silver compound (or alcohol slurry thereof).

Although established, the term "aliphatic hydrocarbon monoamine" in this description refers to a compound composed of one to three monovalent aliphatic hydrocarbon groups and one amino group. The "hydrocarbon group" refers to a group only composed of carbon and hydrogen. However, if necessary, each of the aliphatic hydrocarbon monoamine (A) and the aliphatic hydrocarbon monoamine (B) may have, on its hydrocarbon group, a substituent group containing a hetero atom (atom other than carbon and hydrogen) such as an oxygen atom or a nitrogen atom. This nitrogen atom does not constitute an amino group.

Further, the "aliphatic hydrocarbon diamine" refers to a compound composed of a bivalent aliphatic hydrocarbon group (alkylene group), two amino groups between which said aliphatic hydrocarbon group is interposed, and, if necessary, aliphatic hydrocarbon group(s) (alkyl group(s)) substituted for hydrogen atom(s) on the amino group(s). However, if necessary, the aliphatic hydrocarbon diamine (C) may have, on its hydrocarbon group, a substituent group containing a hetero atom (atom other than carbon and hydrogen) such as an oxygen atom or a nitrogen atom. This nitrogen atom does not constitute an amino group.

The aliphatic hydrocarbon monoamine (A) having 6 or more carbon atoms in total has, due to its hydrocarbon chain, high performance as a protective agent (stabilizer) onto the surfaces of resulting silver particles.

The aliphatic hydrocarbon monoamine (A) includes a primary amine, a secondary amine, and a tertiary amine. Examples of the primary amine include saturated aliphatic hydrocarbon monoamines (i.e., alkylmonoamines) having a C6 to C18 linear aliphatic hydrocarbon group such as hexylamine, heptylamine, octylamine, nonylamine, decylamine, undecylamine, dodecylamine, tridecylamine, tetradecylamine, pentadecylamine, hexadecylamine, heptadecylamine, and octadecylamine. Examples of the saturated aliphatic hydrocarbon monoamine other than the above-mentioned linear aliphatic monoamines include branched aliphatic hydrocarbon monoamines having a C6 to C16, preferably C6 to C8 branched aliphatic hydrocarbon group such as isohexylamine, 2-ethylhexylamine, and tert-octylamine. Another example of the saturated aliphatic hydrocarbon monoamine includes cyclohexylamine. Other examples of the primary amine include unsaturated aliphatic hydrocarbon monoamines (i.e., alkenylmonoamines) such as oleylamine.

Examples of the secondary amine include linear dialkylmonoamines such as N,N-dipropylamine, N,N-dibutylamine, N,N-dipentylamine, N,N-dihexylamine, N,N-dipeptylamine, N,N-dioctylamine, N,N-dinonylamine, N,N-didecylamine, N,N-diundecylamine, N,N-didodecylamine, N-methyl-N-propylamine, N-ethyl-N-propylamine, and N-propyl-N-butylamine. Examples of the tertiary amine include tributylamine and trihexylamine.

Other examples of the secondary amine include branched secondary amines such as N,N-diisohexylamine and N,N-di(2-ethylhexyl)amine. Examples of the tertiary amine include triisohexylamine and tri(2-ethylhexyl)amine. In the case of N,N-di(2-ethylhexyl)amine, the number of carbon atoms in a 2-ethylhexyl group is 8, but the total number of carbon atoms contained in the amine compound is 16. In the case of tri(2-ethylhexyl)amine, the total number of carbon atoms contained in the amine compound is 24.

Among the above-mentioned monoamines (A), regarding the linear monoamines, saturated aliphatic hydrocarbon monoamines having 6 or more carbon atoms are preferred. When the number of carbon atoms is 6 or more, space can be secured between silver particles by adsorption of amino groups to the surfaces of the silver particles, thereby improving the effect of preventing agglomeration of the silver particles. The upper limit of the number of carbon atoms is not particularly limited, but saturated aliphatic monoamines having up to 18 carbon atoms are usually preferred in consideration of ease of availability, ease of removal during calcining, etc. Particularly, alkylmonoamines having 6 to 12 carbon atoms such as hexylamine, heptylamine, octylamine, nonylamine, decylamine, undecylamine, and dodecylamine are preferably used. The above-mentioned linear aliphatic hydrocarbon monoamines may be used singly or in combination of two or more of them.

The use of the branched aliphatic hydrocarbon monoamine compound makes it possible to coat a larger surface area of silver particles due to the steric factor of its branched aliphatic hydrocarbon group even when the amount of the branched aliphatic hydrocarbon monoamine compound attached to the surfaces of the silver particles is reduced, as compared to when the linear aliphatic hydrocarbon monoamine compound having the same carbon number is used. Therefore, silver nano-particles can be properly stabilized even when the amount of the branched aliphatic hydrocarbon monoamine compound attached to the surfaces of the silver particles is reduced. The amount of a protective agent (organic stabilizer) that should be removed during calcining is reduced, and therefore the organic stabilizer can be efficiently removed even by low-temperature calcining at a temperature of 200°C or less, thereby allowing the silver particles to be sufficiently sintered.

Among the above-mentioned branched aliphatic hydrocarbon monoamines, preferred are branched alkylmonoamine compounds whose main chain has 5 to 6 carbon atoms, such as isohexylamine and 2-ethylhexylamine. When the main chain has 5 to 6 carbon atoms, it is easy to properly stabilize silver nano-particles. Further, from the viewpoint of the steric factor of the branched aliphatic group, like 2-ethylhexylamine, branching at the second carbon atom from the N-atom side is effective. The above-mentioned branched aliphatic monoamines may be used singly or in combination of two or more of them.

In the present invention, the linear aliphatic hydrocarbon monoamine and the branched aliphatic hydrocarbon monoamine may be used in combination as the aliphatic hydrocarbon monoamine (A) to obtain their respective advantages.

The aliphatic hydrocarbon monoamine (B) having 5 or less carbon atoms in total has a shorter carbon chain than the aliphatic monoamine (A) having 6 or more carbon atoms in total, and therefore the function of the aliphatic hydrocarbon monoamine (B) itself as a protective agent (stabilizer) is considered to be low. However, the aliphatic hydrocarbon monoamine (B) has a high ability to coordinate to silver in the silver compound due to its higher polarity than the aliphatic monoamine (A), and is therefore considered to have the effect of promoting complex formation. In addition, the aliphatic hydrocarbon monoamine (B) has a short carbon chain, and therefore can be removed from the surfaces of silver particles in a short time of 30 minutes or less, or 20 minutes or less, even by low-temperature calcining at a temperature of, for example, 120°C or less, or about 100°C or less, which is effective for low-temperature calcining of resulting silver nano-particles.

Examples of the aliphatic hydrocarbon monoamine (B) include saturated aliphatic hydrocarbon monoamines (i.e., alkylmonoamines) having 2 to 5 carbon atoms such as ethylamine, n-propylamine, isopropylamine, n-butylamine, isobutylamine, sec-butylamine, tert-butylamine, pentylamine, isopentylamine, and tert-pentylamine. Other examples of the aliphatic hydrocarbon monoamine (B) include dialkylmonoamines such as N,N-dimethylamine and N,N-diethylamine.

Among them, n-butylamine, isobutylamine, sec-butylamine, tert-butylamine, pentylamine, isopentylamine, tert-pentylamine, and the like are preferred, and the above-mentioned butylamines are particularly preferred. The above-mentioned aliphatic hydrocarbon monoamines (B) may be used singly or in combination of two or more of them.

The aliphatic hydrocarbon diamine (C) having 8 or less carbon atoms in total has a high ability to coordinate to silver in the silver compound, and therefore has the effect of promoting complex formation. Generally, aliphatic hydrocarbon diamines have higher polarity than aliphatic hydrocarbon monoamines, and therefore have a high ability to coordinate to silver in a silver compound. Further, the aliphatic hydrocarbon diamine (C) has the effect of promoting lower-temperature and shorter-time thermal decomposition in the thermal-decomposition step of the complex compound, and therefore production of silver nano-particles can be more efficiently conducted. Further, a protective film containing the aliphatic diamine (C) on silver particles has high polarity, which improves the dispersion stability of the silver particles in a dispersion medium comprising a highly-polar solvent. Furthermore, the aliphatic diamine (C) has a short carbon chain, and therefore can be removed from the surfaces of silver particles in a short time of 30 minutes or less, or 20 minutes or less, even by low-temperature calcining at a temperature of, for example, 120°C or less, or about 100°C or less, which is effective for low-temperature and short-time calcining of resulting silver nano-particles.

The aliphatic hydrocarbon diamine (C) is not particularly limited, and examples thereof include ethylenediamine, N,N-dimethylethylenediamine, N,N'-dimethylethylenediamine, N,N-diethylethylenediamine, N,N'-diethylethylenediamine, 1,3-propanediamine, 2,2-dimethyl-1,3-propanediamine, N,N-dimethyl-1,3-propanediamine, N,N'-dimethyl-1,3-propanediamine, N,N-diethyl-1,3-propanediamine, N,N'-diethyl-1,3-propanediamine, 1,4-butanediamine, N,N-dimethyl-1,4-butanediamine, N,N'-dimethyl-1,4-butanediamine, N,N-diethyl-1,4-butanediamine, N,N'-diethyl-1,4-butanediamine, 1,5-pentanediamine, 1,5-diamino-2-methylpentane, 1,6-hexanediamine, N,N-dimethyl-1,6-hexanediamine, N,N'-dimethyl-1,6-hexanediamine, 1,7-heptanediamine, 1,8-octanediamine, and the like. They are all alkylenediamines having 8 or less carbon atoms in total in which at least one of the two amino groups is a primary amino group or a secondary amino group, and have a high ability to coordinate to silver in the silver compound, and therefore have the effect of promoting complex formation.

Among them, N,N-dimethylethylenediamine, N,N-diethylethylenediamine, N,N-dimethyl-1,3-propanediamine, N,N-diethyl-1,3-propanediamine, N,N-dimethyl-1,4-butanediamine, N,N-diethyl-1,4-butanediamine, N,N-dimethyl-1,6-hexanediamine, and the like are preferred, which are alkylenediamines having 8 or less carbon atoms in total in which one of the two amino groups is a primary amino group (-NH₂) and the other is a tertiary amino group (-NR¹R²). Such preferred alkylenediamines are represented by the following structural formula:

R¹R²N-R-NH₂

wherein R represents a bivalent alkylene group, R¹ and R² may be the same or different from each other and each represent an alkyl group, and the total number of carbon atoms of R, R¹, and R² is 8 or less. The alkylene group does not usually contain a hetero atom (atom other than carbon and hydrogen) such as an oxygen atom or a nitrogen atom, but if necessary, may have a substituent group containing such a hetero atom. Further, the alkyl group does not usually contain a hetero atom such as an oxygen atom or a nitrogen atom, but if necessary, may have a substituent group containing such a hetero atom.

When one of the two amino groups is a primary amino group, the ability to coordinate to silver in the silver compound is high, which is advantageous for complex formation, and when the other is a tertiary amino group, a resulting complex is prevented from having a complicated network structure because a tertiary amino group has a poor ability to coordinate to a silver atom. If a complex has a complicated network structure, there is a case where the thermal-decomposition step of the complex requires a high temperature. Among these diamines, those having 6 or less carbon atoms in total are preferred, and those having 5 or less carbon atoms in total are more preferred in terms of the fact that they can be removed from the surfaces of silver particles in a short time even by low-temperature calcining. The above-mentioned aliphatic hydrocarbon diamines (C) may be used singly or in combination of two or more of them.

The ratio between the aliphatic hydrocarbon monoamine (A) having 6 or more carbon atoms in total, and one or both of the aliphatic hydrocarbon monoamine (B) having 5 or less carbon atoms in total and the aliphatic hydrocarbon diamine (C) having 8 or less carbon atoms in total used in the present invention is not particularly limited. For example,
the amount of the aliphatic monoamine (A) may be 5 mol% to 65 mol%; and
the total amount of the aliphatic monoamine (B) and the aliphatic diamine (C) may be 35 mol% to 95 mol%,
on the basis of the total amount of the amines [(A) + (B) + (C)] .

By setting the content of the aliphatic monoamine (A) to 5 mol% to 65 mol%, the carbon chain of the component (A) can easily fulfill its function of protecting and stabilizing the surfaces of resulting silver particles. If the content of the component (A) is less than 5 mol%, there is a case where the protective and stabilization function is poorly developed. On the other hand, if the content of the component (A) exceeds 65 mol%, the protective and stabilization function is sufficient, but the component (A) is poorly removed by low-temperature calcining. When the branched aliphatic monoamine is used as the component (A),
the amount of the branched aliphatic monoamine may be 10 mol% to 50 mol%,
to satisfy that the content of the aliphatic monoamine (A) is 5 mol% to 65 mol%.

When the aliphatic monoamine (A), and further both the aliphatic monoamine (B) and the aliphatic diamine (C) are used, the ratio among them used is not particularly limited. For example,
the amount of the aliphatic monoamine (A) may be 5 mol% to 65 mol%;
the amount of the aliphatic monoamine (B) may be 5 mol% to 70 mol%; and
the amount of the aliphatic diamine (C) may be 5 mol% to 50 mol%, on the basis of the total amount of the amines [(A) + (B) + (C)]. When the branched aliphatic monoamine is used as the component (A),
the amount of the branched aliphatic monoamine may be 10 mol% to 50 mol%,
to satisfy that the content of the aliphatic monoamine (A) is 5 mol% to 65 mol%.

In this case, the lower limit of the content of the component (A) is preferably 10 mol% or more, more preferably 20 mol% or more. The upper limit of the content of the component (A) is preferably 65 mol% or less, more preferably 60 mol% or less.

By setting the content of the aliphatic monoamine (B) to 5 mol% to 70 mol%, the effect of promoting complex formation is easily obtained, the aliphatic monoamine (B) itself can contribute to low-temperature and short-time calcining, and the effect of facilitating the removal of the aliphatic diamine (C) from the surfaces of silver particles during calcining is easily obtained. If the content of the component (B) is less than 5 mol%, there is a case where the effect of promoting complex formation is poor, or the component (C) is poorly removed from the surfaces of silver particles during calcining. On the other hand, if the content of the component (B) exceeds 70 mol%, the effect of promoting complex formation is obtained, but the content of the aliphatic monoamine (A) is relatively reduced so that the surfaces of resulting silver particles are poorly protected and stabilized. The lower limit of the content of the component (B) is preferably 10 mol% or more, more preferably 15 mol% or more. The upper limit of the content of the component (B) is preferably 65 mol% or less, more preferably 60 mol% or less.

By setting the content of the aliphatic diamine (C) to 5 mol% to 50 mol%, the effect of promoting complex formation and the effect of promoting the thermal-decomposition of the complex are easily obtained, and further, the dispersion stability of silver particles in a dispersion medium containing a highly-polar solvent is improved because a protective film containing the aliphatic diamine (C) on silver particles has high polarity. If the content of the component (C) is less than 5 mol%, there is a case where the effect of promoting complex formation and the effect of promoting the thermal-decomposition of the complex are poor. On the other hand, if the content of the component (C) exceeds 50 mol%, the effect of promoting complex formation and the effect of promoting the thermal-decomposition of the complex are obtained, but the content of the aliphatic monoamine (A) is relatively reduced so that the surfaces of resulting silver particles are poorly protected and stabilized. The lower limit of the content of the component (C) is preferably 5 mol% or more, more preferably 10 mol% or more. The upper limit of the content of the component (C) is preferably 45 mol% or less, more preferably 40 mol% or less.

When the aliphatic monoamine (A) and the aliphatic monoamine (B) are used (without using the aliphatic diamine (C)), the ratio between them used is not particularly limited. For example, in consideration of the above-described functions of these components,
the amount of the aliphatic monoamine (A) may be 5 mol% to 65 mol%; and
the amount of the aliphatic monoamine (B) may be 35 mol% to 95 mol%,
on the basis of the total amount of the amines [(A) + (B)]. When the branched aliphatic monoamine is used as the component (A), the amount of the branched aliphatic monoamine may be 10 mol% to 50 mol%,
to satisfy that the content of the aliphatic monoamine (A) is 5 mol% to 65 mol%.

When the aliphatic monoamine (A) and the aliphatic diamine (C) are used (without using the aliphatic monoamine (B)), the ratio between them used is not particularly limited. For example, in consideration of the above-described functions of these components,
the amount of the aliphatic monoamine (A) may be 5 mol% to 65 mol%; and
the amount of the aliphatic diamine (C) may be 35 mol% to 95 mol%,
on the basis of the total amount of the amines [(A) + (C)]. When the branched aliphatic monoamine is used as the component (A), the amount of the branched aliphatic monoamine may be 10 mol% to 50 mol%,
to satisfy that the content of the aliphatic monoamine (A) is 5 mol% to 65 mol%.

The above ratios among/between the aliphatic monoamine (A) and the aliphatic monoamine (B) and/or the aliphatic diamine (C) used are examples and may be changed in various manners.

In the present invention, the use of the aliphatic monoamine (B) and/or the aliphatic diamine (C) each having a high ability to coordinate to silver in the silver compound makes it possible, depending on their contents, to reduce the amount of the aliphatic monoamine (A) having 6 or more carbon atoms in total adhered to the surfaces of silver particles. Therefore, these aliphatic amine compounds are easily removed from the surfaces of silver particles even by the above-described low-temperature and short-time calcining so that the silver particles (N) are sufficiently sintered.

In the present invention, the total amount of the aliphatic hydrocarbon amine [e.g., (A) and (B) and/or (C)] is not particularly limited, but may be about 1 to 50 moles per 1 mole of silver atoms in the silver compound as a starting material. If the total amount of the amine components [(A) and (B) and/or (C)] is less than 1 mole per 1 mole of the silver atoms, there is a possibility that part of the silver compound remains without being converted to a complex compound in the complex compound-forming step so that, in the subsequent thermal decomposition step, silver particles have poor uniformity and become enlarged or the silver compound remains without being thermally decomposed. On the other hand, it is considered that even when the total amount of the amine components [(A) and (B) and/or (C)] exceeds about 50 moles per 1 mole of the silver atoms, there are few advantages. In order to prepare a dispersion liquid of silver nano-particles in substantially the absence of solvent, the total amount of the amine components may be, for example, about 2 moles or more. By setting the total amount of the amine components to about 2 to 50 moles, the complex compound-forming step and the thermal-decomposition step of the complex compound can be successfully performed. The lower limit of the total amount of the amine components is preferably 2 moles or more, more preferably 6 moles or more per 1 mole of silver atoms in the silver compound. It is to be noted that the molecule of silver oxalate contains two silver atoms.

In the present invention, an aliphatic carboxylic acid (D) may further be used as a stabilizer to further improve the dispersibility of silver nano-particles (N) in a dispersion medium. The aliphatic carboxylic acid (D) may be used together with the above-described amines, and may be used by adding to the above-described amine mixture liquid. The use of the aliphatic carboxylic acid (D) may improve the stability of silver nano-particles, especially the stability of silver nano-particles in a coating material state where the silver nano-particles are dispersed in an organic solvent.

As the aliphatic carboxylic acid (D), a saturated or unsaturated aliphatic carboxylic acid is used. Examples of the aliphatic carboxylic acid include saturated aliphatic monocarboxylic acids having 4 or more carbon atoms such as butanoic acid, pentanoic acid, hexanoic acid, heptanoic acid, octanoic acid, nonanoic acid, decanoic acid, undecanoic acid, dodecanoic acid, tridecanoic acid, tetradecanoic acid, pentadecanoic acid, hexadecanoic acid, heptadecanoic acid, octadecanoic acid, nonadecanoic acid, icosanoic acid, and eicosenoic acid; and unsaturated aliphatic monocarboxylic acids having 8 or more carbon atoms such as oleic acid, elaidic acid, linoleic acid, and palmitoleic acid.

Among them, saturated or unsaturated aliphatic monocarboxylic acids having 8 to 18 carbon atoms are preferred. When the number of carbon atoms is 8 or more, space can be secured between silver particles by adsorption of carboxylic groups to the surfaces of the silver particles, thereby improving the effect of preventing agglomeration of the silver particles. In consideration of ease of availability, ease of removal during calcining, etc., saturated or unsaturated aliphatic monocarboxylic compounds having up to 18 carbon atoms are usually preferred. Particularly, octanoic acid, oleic acid, and the like are preferably used. The above-mentioned aliphatic carboxylic acids (D) may be used singly or in combination of two or more of them.

When the aliphatic carboxylic acid (D) is used, the amount of the aliphatic carboxylic acid (D) used may be, for example, about 0.05 to 10 moles, preferably 0.1 to 5 moles, more preferably 0.5 to 2 moles per 1 mole of silver atoms in the silver compound as a starting material. If the amount of the component (D) is less than 0.05 moles per 1 mole of the silver atoms, the effect of improving dispersion stability obtained by adding the component (D) is poor. On the other hand, if the amount of the component (D) reaches 10 moles, the effect of improving dispersion stability is saturated and the component (D) is poorly removed by low-temperature calcining. It is to be noted that the aliphatic carboxylic acid (D) does not necessarily need to be used in consideration of removal of the component (D) by low-temperature calcining.

In the present invention, a mixture liquid containing the respective aliphatic hydrocarbon amine components used, for example, an amine mixture liquid containing the aliphatic monoamine (A) and further one or both of the aliphatic monoamine (B) and the aliphatic diamine (C) is usually prepared [preparation step for amine mixture liquid].

The amine mixture liquid can be prepared by stirring the amine component (A), the amine component (B) and/or the amine component (C), and if used, the carboxylic acid component (D) in a given ratio at a room temperature.

The aliphatic hydrocarbon amine mixture liquid containing the respective amine components is added to the silver compound (or alcohol slurry thereof) to form a complex compound comprising the silver compound and the amine [complex compound-forming step]. The amine components may be added to the silver compound (or alcohol slurry thereof) one by one without using a mixture liquid thereof.

When metal nano-particles containing another metal other than silver are produced, a metal compound containing a desired metal (or alcohol slurry thereof) is used instead of the silver compound (or alcohol slurry thereof).

The silver compound (or alcohol slurry thereof) or the metal compound (or alcohol slurry thereof), and a given amount of the amine mixture liquid are mixed. The mixing may be performed at ordinary temperature. The "ordinary temperature" refers to 5 to 40°C depending on ambient temperature. For example, the ordinary temperature refers to 5 to 35°C (JIS Z 8703), 10 to 35°C, or 20 to 30°C. The ordinary temperature may be a normal room temperature (e.g., 15 to 30°C) . At this time, the mixing may be performed by stirring them, or may be performed by stirring them while a mixture of them is appropriately cooled to a temperature within the above range, for example, about 5 to 15°C because the coordination reaction of the amines to the silver compound (or the metal compound) is accompanied by heat generation. When the mixing of the silver compound and the amine mixture liquid is performed in the presence of an alcohol having 3 or more carbon atoms, stirring and cooling can be successfully performed. The alcohol and excess amines function as a reaction medium.

In a method for thermally decomposing a silver-amine complex, conventionally, a liquid aliphatic amine component is first placed in a reaction container, and then a powder silver compound (silver oxalate) is added thereto. The liquid aliphatic amine component is flammable, and therefore addition of the powder silver compound to the liquid aliphatic amine compound is dangerous. That is, there is a risk of ignition due to static electricity generated by addition of the powder silver compound. Further, there is also a risk of a runaway exothermic reaction due to a complex-forming reaction locally caused by addition of the powder silver compound. Such risks can be avoided by mixing the silver compound and the amine mixture liquid in the presence of the above-mentioned alcohol. Therefore, scaled-up industrial-level production is also safely performed.

When a complex compound is formed, the formed complex compound generally exhibits a color corresponding to its components, and therefore the endpoint of a complex compound-forming reaction can be determined by detecting the end of a change in the color of a reaction mixture by an appropriate spectroscopic method or the like. A complex compound formed from silver oxalate is generally colorless (appears white to our eyes), but even in such a case, it is possible to determine the state of formation of a complex compound based on a change in the form of a reaction mixture such as a change in viscosity. For example, the time of formation reaction of the complex compound is about 30 minutes to 3 hours. In this way, a silver-amine complex (or a metal-amine complex) is obtained in a medium mainly containing the alcohol and the amines.

Then, the obtained complex compound is thermally decomposed by heating to form silver nano-particles (N) (thermal-decomposition step of complex compound]. When a metal compound containing another metal other than silver is used, desired metal nano-particles are formed. The silver nano-particles (metal nano-particles) are formed without using a reducing agent. However, if necessary, an appropriate reducing agent may be used without impairing the effects of the present invention.

In such a metal-amine complex decomposition method, the amines generally play a role in controlling the mode of formation of fine-particles by agglomeration of an atomic metal generated by decomposition of the metal compound, and in forming film on the surfaces of the formed metal fine-particles to prevent reagglomeration of the fine-particles. That is, it is considered that when the complex compound of the metal compound and the amine is heated, the metal compound is thermally decomposed to generate an atomic metal while the coordination bond of the amine to a metallic atom is maintained, and then the metallic atoms coordinated with the amine are agglomerated to form metal nano-particles coated with an amine protective film.

At this time, the thermal decomposition is preferably performed by stirring the complex compound in a reaction medium mainly containing the alcohol (used if necessary) and the amines. The thermal decomposition may be performed in a temperature range in which coated silver nano-particles (or coated metal nano-particles) are formed, but from the viewpoint of preventing the elimination of the amine from the surfaces of silver particles (or from the surfaces of metal particles), the thermal decomposition is preferably performed at a temperature as low as possible within such a temperature range. In the case of the complex compound from silver oxalate, the thermal decomposition temperature may be, for example, about 80°C to 120°C, preferably about 95°C to 115°C, more specifically about 100°C to 110°C. In the case of the complex compound from silver oxalate, heating at about 100°C allows decomposition and reduction of silver ions to occur so that coated silver nano-particles can be obtained. Further, the thermal decomposition of silver oxalate itself generally occurs at about 200°C. The reason why the thermal decomposition temperature of a silver oxalate-amine complex compound is about 100°C lower than that of silver oxalate itself is not clear, but it is estimated that a coordination polymer structure formed by pure silver oxalate is broken by forming a complex compound of silver oxalate with the amine.

Further, the thermal decomposition of the complex compound is preferably performed in an inert gas atmosphere such as argon, but may be performed in the atmosphere.

When the complex compound is thermally decomposed, a suspension exhibiting a glossy blue color is obtained. Then, the excess amines, etc. are removed from the suspension by, for example, sedimentation of silver nano-particles (or metal nano-particles) and decantation and washing with an appropriate solvent (water or an organic solvent) to obtain desired stable coated silver nano-particles (N) (or coated metal nano-particles) [silver nano-particle post-treatment step]. After the washing, the coated silver nano-particles are dried to obtain a powder of the desired stable coated silver nano-particles (or coated metal nano-particles). However, wet silver nano-particles (N) may be used to prepare silver nanoparticle-containing ink.

The decantation and washing are performed using water or an organic solvent. Examples of the organic solvent that may be used include aliphatic hydrocarbon solvents such as pentane, hexane, heptane, octane, nonane, decane, undecane, dodecane, tridecane, and tetradecane; alicyclic hydrocarbon solvents such as cyclohexane; aromatic hydrocarbon solvents such as toluene, xylene, and mesitylene; alcohol solvents such as methanol, ethanol, propanol, and butanol; acetonitrile; and mixed solvents of them.

In consideration of using the silver particle coating composition for intaglio offset printing, the organic solvent used for decantation and washing may be a glycol-based solvent. Examples of the glycol-based solvent include glycol monoethers such as ethylene glycol monomethyl ether, diethylene glycol monomethyl ether, ethylene glycol monoethyl ether, diethylene glycol monoethyl ether, ethylene glycol monobutyl ether, diethylene glycol monobutyl ether, propylene glycol monomethyl ether, and dipropylene glycol monomethyl ether. The above-mentioned glycol-based solvents may be used singly or in combination of two or more of them.

The step of forming the silver nano-particles according to the present invention does not require the use of a reducing agent. Therefore, a by-product derived from a reducing agent is not formed, coated silver nano-particles are easily separated from a reaction system, and high-purity coated silver nano-particles (N) are obtained. However, if necessary, an appropriate reducing agent may be used without impairing the effects of the present invention.

In this way, silver nano-particles (N) whose surfaces are coated with a protective agent used are formed. The protective agent comprises, for example, the aliphatic monoamine (A), and further one or both of the aliphatic monoamine (B) and the aliphatic diamine (C), and further if used, the carboxylic acid (D). The ratio among/between them contained in the protective agent is the same as the ratio among/between them used in the amine mixture liquid. The same matter is true in the metal nano-particles.

### [Silver microparticles (M)]

In this description, the term "microparticles" means that their average particle diameter is 1 µm or more and 10 µm or less. Unlike the above-mentioned silver nano-particles (N), the silver microparticles (M) have no aliphatic hydrocarbon amine protective agent on their surfaces. In the present invention, the silver microparticles may be spherical particles or flaky particles. The flaky particles refer to particles having an aspect ratio, which is the ratio of the diameter to the thickness of the microparticles (diameter/thickness), of, for example, 2 or more. The flaky particles have a larger area of contact among them than spherical particles, so that conductivity tends to be improved. Further, the silver microparticles (M) has an average particle diameter at 50% of cumulative particle size distribution D50 of, for example, 1 µm to 5 µm, preferably 1 µm to 3 µm. When the silver coating composition is used for gravure offset printing, the particles are preferably small from the viewpoint of drawing fine lines (e.g., L/S = 30/30 µm). Examples of the silver microparticles include Silbest TC-507A (shape: flaky, D50: 2.78 µm), Silbest AgS-050 (shape: spherical, D50: 1.4 µm), Silbest C-34 (shape: spherical, D50: 0.6 µm) and the like that are manufactured by TOKURIKI HONTEN CO., LTD. The particle diameter is calculated by laser diffractometry.

### [Mixing ratio between silver nano-particles (N) and silver microparticles (M)]

The amount of the silver nano-particles (N) is 10 to 90% by weight; and
the amount of the silver microparticles (M) may be 10 to 90% by weight,
on the basis of the total amount of the silver nano-particles (N) and the silver microparticles (M). Such a mixing ratio makes it easy to obtain the effect of the silver nano-particles (N) on improving conductivity by low-temperature calcining, and the effect of the silver microparticles (M) on improving stability of the silver coating composition.

If the amount of the silver nano-particles (N) is less than 10% by weight, the amount of the silver nano-particles (N) filling gaps among the silver microparticles (M) is small, and therefore it is difficult to obtain the effect of improving contact among the silver microparticles (M). Further, the effect of the silver nano-particles (N), whose surfaces are coated with a protective agent containing an aliphatic hydrocarbon amine, obtained by low-temperature calcining becomes relatively small. For these reasons, it is difficult to obtain the conductivity-improving effect by low-temperature calcining. On the other hand, if the amount of the silver nano-particles (N) exceeds 90% by weight, there is a case where the storage stability of the silver coating composition is reduced. The silver nano-particles (N) used in the present invention are particles whose surfaces are coated with a protective agent containing an aliphatic hydrocarbon amine, and are suitable for low-temperature calcining. However, there is a case where the silver nano-particles (N) are gradually sintered even during the storage of the coating composition. Such sintering causes an increase in viscosity of the coating composition. From such a viewpoint, the silver microparticles (M), which are stable even at about ordinary temperature, are preferably used in an amount of 10% by weight or more.

Preferably,
the amount of the silver nano-particles (N) may be 30 to 80% by weight; and
the amount of the silver microparticles (M) may be 20 to 70% by weight, and more preferably,
the amount of the silver nano-particles (N) may be 50 to 75% by weight; and
the amount of the silver microparticles (M) may be 25 to 50% by weight.

### [Dispersion solvent]

The dispersion solvent may be a solvent capable of well dispersing the silver nano-particles (N) and the silver microparticles (M). Examples of the organic solvent used to obtain the silver coating composition include: aliphatic hydrocarbon solvents such as pentane, hexane, heptane, octane, nonane, decane, undecane, dodecane, tridecane, and tetradecane; alicyclic hydrocarbon solvents such as cyclohexane and methylcyclohexane; aromatic hydrocarbon solvents such as toluene, xylene, and mesitylene; alcohol solvents such as methanol, ethanol, propanol, n-butanol, n-pentanol, n-hexanol, n-heptanol, n-octanol, n-nonanol, and n-decanol; glycol-based solvents; glycol ester-based solvents; and terpene-based solvents such as terpineol and dihydroterpineol. The kind and amount of organic solvent used may be appropriately determined depending on a desired concentration or viscosity of the silver coating composition (silver ink, silver paste) . The same matter is true in the metal nano-particles.

The dispersion solvent to be used is preferably a glycol-based solvent or a glycol ester-based solvent in consideration of using the silver particle coating composition for intaglio offset printing. Examples of the glycol-based solvent include those mentioned above as examples of the organic solvent used for decantation and washing of the silver nano-particles (N), such as glycol monoethers such as ethylene glycol monomethyl ether, diethylene glycol monomethyl ether, ethylene glycol monoethyl ether, diethylene glycol monoethyl ether, ethylene glycol monobutyl ether, diethylene glycol monobutyl ether (butyl carbitol: BC), propylene glycol monomethyl ether, and dipropylene glycol monomethyl ether. The above-mentioned glycol-based solvents may be used singly or in combination of two or more of them. The glycol-based solvent may be derived from one used for decantation and washing of the silver nano-particles (N).

Examples of the glycol ester-based solvent include glycol monoesters such as ethylene glycol monomethyl ether acetate, diethylene glycol monomethyl ether acetate, ethylene glycol monoethyl ether acetate, diethylene glycol monoethyl ether acetate, ethylene glycol monobutyl ether acetate, diethylene glycol monobutyl ether acetate (butyl carbitol acetate: BCA), propylene glycol monomethyl ether acetate (PMA: 1-methoxy-2-propyl acetate), and dipropylene glycol monomethyl ether acetate. The above-mentioned glycol ester-based solvents may be used singly or in combination of two or more of them.

The glycol-based solvent or the glycol ester-based solvent has the property of penetrating into a blanket made of silicone in intaglio offset printing. The penetration of the solvent into the blanket dries the interface between the blanket and the ink, which reduces adhesion between the ink and the blanket. This is effective at improving transferability of the ink from the blanket to a substrate. Further, the glycol-based solvent or the glycol ester-based solvent also has the function of dissolving a binder resin, a curable monomer, and a polymerization initiator that will be described later. Further, these solvents have low volatility, which is preferred because the concentration of the silver ink is less likely to change. Also from the viewpoint of working environment, these solvents are preferred due to the low volatility.

In the present invention, the total amount of the dispersion solvent is, for example, 30% by weight or more and 60% by weight or less, preferably 30% by weight or more and 50% by weight or less, more preferably 30% by weight or more and 40% by weight or less with respect to the amount of the silver coating composition. From the viewpoint of using the silver coating composition for intaglio offset printing, if the amount of the dispersion solvent is less than 30% by weight or less, the amount of the solvent is small, and therefore there is a possibility that transfer during printing is not successfully performed. On the other hand, if the amount of the dispersion solvent exceeds 60% by weight, the amount of the solvent is large, and therefore there is a possibility that printing of fine lines is not successfully performed, or there is a possibility that low-temperature calcining is not successfully performed.

### [Binder resin]

In the present invention, the silver coating composition preferably further comprises a binder resin. When the silver coating composition comprises a binder resin, a calcined silver film (conductive pattern) obtained by calcining the silver coating composition applied (or printed) onto a substrate on which the silver coating composition should be printed has improved adhesion to the substrate and improved flexibility.

Examples of the binder resin include a polyvinyl butyral resin, a polyester-based resin, an acrylic resin, an ethyl cellulose-based resin, a phenol-based resin, a polyimide-based resin, a melamine-based resin, and a melamine-polyester-based resin. Among them, a polyvinyl butyral resin and a polyester-based resin are preferred. It is also preferred that both of them are used in combination.

The polyvinyl butyral resin is not particularly limited, but is preferably one having a weight-average molecular weight (Mw) of about 10,000 to 100,000. Examples of a commercially-available product of the polyvinyl butyral resin include S-LEC B Series manufactured by SEKISUI CHEMICAL CO., LTD. The polyester-based resin is not particularly limited, and examples thereof include polycaprolactone triol (Placcel 305 [PCL305] commercially available from Daicel Corporation) and the like. Examples of a commercially-available product of ethyl cellulose include ETHOCEL (trademark of Nissin Kasei Co., Ltd.) Series.

The amount of the binder resin to be added is, for example, about 0.1% by weight or more and 10% by weight or less, preferably about 2% by weight or more and 5% by weight or less with respect to the amount of the silver coating composition. By setting the amount of the binder resin to be added to a value within the above range, it is easy to obtain the effect of improving adhesion between a calcined silver film and a substrate, and the effect of improving flexibility of a calcined silver film.

### [Curable monomer and polymerization initiator]

In the present invention, the silver coating composition preferably further comprises a curable monomer and a polymerization initiator. When the silver particle coating composition comprises a curable monomer and a polymerization initiator, adhesion between a calcined silver film and a substrate is further improved, and flexibility of a calcined silver film is improved. This improves followability of the calcined silver film to a flexible substrate such as a plastic substrate.

Examples of the curable monomer include an oxetane compound, an epoxy compound and the like. These compounds have cationic polymerizability.

The oxetanyl compound may be a monofunctional oxetanyl compound having one oxetanyl group in its molecule, but is preferably a polyfunctional oxetanyl compound having two or more oxetanyl groups in its molecule. Examples of the monofunctional oxetanyl compound include 3-ethyl-3-hydroxymethyloxetane (ARON OXETANE Series OXT-101 commercially available from TOAGOSEI CO., LTD.) and the like. Examples of the polyfunctional oxetanyl compound include bifunctional oxetanyl compounds such as 1,4-bis{[(3-ethyl-3-oxetanyl)methoxy]methyl}benzene, 3-ethyl-3-(phenoxymethyl)oxetane, di[1-ethyl(3-oxetanyl)]methyl ether (OXT-221 commercially available from TOAGOSEI CO., LTD.), and 3-ethyl-3-(2-ethylhexyloxymethyl)oxetane. Other examples of the polyfunctional oxetanyl compound include phenol novolac oxetane (PNOX commercially available from TOAGOSEI CO., LTD.) and the like. These oxetanyl compounds may be used singly or in combination of two or more of them.

The epoxy compound may be a monofunctional epoxy compound having one epoxy group in its molecule, but is preferably a polyfunctional epoxy compound having two or more epoxy groups in its molecule. Examples of the polyfunctional epoxy compound include: glycidyl ethers such as bisphenol A diglycidyl ether, bisphenol A di-β-methylglycidyl ether, bisphenol F di-glycidyl ether, bisphenol F di-β-methylglycidyl ether, novolac-type epoxy resins, trisphenol methane triglycidyl ether, 1,4-butanediol diglycidyl ether, 1,6-hexanediol diglycidyl ether, glycerol triglycidyl ether, trimethylol propane triglycidyl ether, propylene glycol diglycidyl ether, and polyethylene glycol diglycidyl ether; diglycidyl esters such as diglycidyl phthalate, diglycidyl tetrahydrophthalate, and dimer acid diglycidyl esters; and the like. These polyfunctional epoxy compounds may be used singly or in combination of two or more of them.

The polymerization initiator may be any polymerization initiator that initiates polymerization via heat or UV, but is preferably a thermal polymerization initiator due to the necessity of sintering of the silver nano-particles. Examples of such a cationic catalyst include aryldiazonium salts, aryliodonium salts, arylsulfonium salts, allene-ion complexes, and the like. Examples of a commercially-available product of the polymerization initiator usable in the present invention include: "PP-33", "CP-66", and "CP-77" (trade names) (which are all manufactured by ADEKA CORPORATION); "FC-509" (trade name) (which is manufactured by 3M); "UVE1014" (trade name) (which is manufactured by G.E.); "San-Aid SI-60L", "San-Aid SI-80L, "San-Aid SI 100L", and "San-Aid SI-110L" (trade names) (which are all manufactured by SANSHIN CHEMICAL INDUSTRY CO., LTD.); "CG-24-61" (trade name) (which is manufactured by Ciba Japan K.K.) and the like. In the present invention, the polymerization initiator is preferably one that initiates a curing reaction at about 120°C (e.g., SI-100L) from the viewpoint of low-temperature calcining (120°C or lower), catalyst lifetime, and storage stability.

The amount of the curable monomer to be added is, for example, about 0.1% by weight or more and 10% by weight or less, preferably about 2% by weight or more and 5% by weight or less with respect to the amount of the silver coating composition. By setting the amount of the curable monomer to be added to a value within the above range, it is easy to obtain the effect of improving adhesion between a calcined silver film and a substrate, and the effect of improving flexibility of a calcined silver film. If the amount of the curable monomer to be added is too large, contact among the silver particles tends to be inhibited so that conductivity is reduced. If the amount of the curable monomer to be added is too small, flexibility of a calcined silver film is less likely to be improved, and therefore adhesion between a calcined silver film and a substrate is less likely to be improved. The curing is preferably thermal curing, but may be radiation curing such as ultraviolet curing. The amount of the polymerization initiator to be added is, for example, about 0.1% by weight or more and 50% by weight or less, preferably about 10% by weight or more and 35% by weight or less with respect to the amount of the curable monomer. The amount of the polymerization initiator to be added may be appropriately selected so that the curable monomer can be cured.

In the present invention, the silver coating composition may further comprise a component other than the above components so that the object of the present invention can be achieved.

In consideration of using the silver coating composition for intaglio offset printing, the viscosity of the silver coating composition (silver ink) is, for example, in the range of 0.1 Pa·s or more and 30 Pa·s or less, preferably in the range of 5 Pa·s or more and 25 Pa·s or less at ambient temperature condition (e.g., 25°C) during printing. If the viscosity of the ink is less than 0.1 Pa·s, flowability of the ink is too high, and therefore there is a fear that a problem occurs with reception of the ink from an intaglio plate by a blanket, or with transfer of the ink from a blanket to a substrate on which the ink should be printed. On the other hand, if the viscosity of the ink exceeds 30 Pa·s, flowability of the ink is too low, and therefore there is a fear that recesses of an intaglio plate are poorly filled with the ink. If the recesses are poorly filled with the ink, the accuracy of a pattern transferred onto a substrate is reduced so that a problem occurs such as fine line disconnection.

The powder of coated silver nano-particles (N) in a dry or wet state obtained in the silver nano-particle post-treatment step, the powder of silver microparticles (M), and the above-mentioned dispersion solvent, and if used, the binder resin, the curable monomer and the polymerization initiator are mixed together with stirring so that ink (or paste) containing suspended silver particles can be prepared. The amount of the silver particles is 10% by weight or more, or, 25% by weight or more, preferably 30% by weight or more as the total amount of the silver nano-particles (N) and the silver microparticles (M) contained in the silver particle-containing ink. The upper limit of the content of the silver particle is 80% by weight or less as a standard. The mixing and dispersing of the coated silver nano-particles (N), the silver microparticles (M), and the dispersion solvent, and if used, the binder resin, the curable monomer and the polymerization initiator may be performed at one time or several times.

The silver coating composition (silver ink) obtained in the present invention has excellent stability. The silver ink is stable at a silver concentration of, for example, 50% by weight during cold storage at 5°C for 1 month or more without causing viscosity increase.

The prepared silver coating composition (silver ink) is applied onto a substrate by a known coating method, for example, by an intaglio offset printing method, and is then calcined.

A patterned silver ink coating layer is obtained by intaglio offset printing and calcined to obtain a patterned silver conductive layer (calcined silver film).

In intaglio offset printing, recesses of an intaglio plate are first filled with the silver ink, the silver ink filled in the recesses is transferred to allow a blanket usually made of silicone rubber to receive the silver ink, and then the silver ink is transferred from the blanket to a substrate. When the silver ink according to the present invention comprises a dispersion solvent containing a glycol ester-based solvent, the dispersion solvent penetrates into the blanket and swells the blanket. Depending on the amount of the solvent that has penetrated into the blanket, the concentration of the silver ink held on the surface of the blanket increases, that is, said silver ink is dried. As a result, adhesion between the silver ink on the surface of the blanket and the blanket is reduced so that transferability of the silver ink from the blanket to the substrate is improved.

When the silver ink further comprises a binder resin, a calcined silver film obtained by calcining the silver ink applied (or printed) onto a substrate on which the silver ink should be printed has improved adhesion to the substrate and improved flexibility. When the silver ink further comprises a curable monomer and a polymerization initiator, adhesion between a calcined silver film and a substrate is further improved, and flexibility of a calcined silver film is further improved. This improves followability of the calcined silver film to a flexible substrate such as a plastic substrate.

The calcining can be performed at 200°C or less, for example, a room temperature (25°C) or more and 150°C or less, preferably a room temperature (25°C) or more and 120°C or less. However, in order to complete the sintering of silver by short-time calcining, the calcining may be performed at a temperature of 60°C or more and 200°C or less, for example, 80°C or more and 150°C or less, preferably 90°C or more and 120°C or less. The time of calcining may be appropriately determined in consideration of the amount of the silver ink applied, the calcining temperature, etc., and may be, for example, several hours (e.g., 3 hours, or 2 hours) or less, preferably 1 hour or less, more preferably 30 minutes or less, even more preferably 10 minutes to 20 minutes.

The silver nano-particles have such a constitution as described above, and are therefore sufficiently sintered even by such low-temperature and short-time calcining. As a result, excellent conductivity (low resistance value) is developed. A silver conductive layer having a low resistance value (e.g., 15 µΩcm or less, in the range of 5 to 15 µΩcm) is formed. The resistance value of bulk silver is 1.6 µΩcm.

Since the calcining can be performed at a low temperature, not only a glass substrate or a heat-resistant plastic substrate such as a polyimide-based film but also a general-purpose plastic substrate having low heat resistance, such as a polyester-based film, e.g., a polyethylene terephthalate (PET) film and a polyethylene naphthalate (PEN) film, or a polyolefin-based film, e.g., polypropylene film, can be suitably used as a substrate. Further, short-time calcining reduces the load on such a general-purpose plastic substrate having low heat resistance, and improves production efficiency.

A silver conductive material obtained according to the present invention can be applied to various electronic devices such as electromagnetic wave control materials, circuit boards, antennas, radiator plates, liquid crystal displays, organic EL displays, field emission displays (FEDs), IC cards, IC tags, solar cells, LED devices, organic transistors, condensers (capacitors), electronic paper, flexible batteries, flexible sensors, membrane switches, touch panels, and EMI shields. Particularly, the silver conductive material is effective as an electronic material required to have surface smoothness, such as a gate electrode of a thin film transistor (TFT) in a liquid crystal display.

The thickness of the silver conductive layer may be appropriately determined depending on the intended use. The thickness of the silver conductive layer is not particularly limited, and may be selected from the range of, for example, 5 nm to 10 µm, preferably 100 nm to 5 µm, more preferably 300 nm to 2 µm.

### EXAMPLES

Hereinbelow, the present invention will be described more specifically with reference to examples, but is not limited to these examples.

### [Specific resistance value of calcined silver film]

The specific resistance value of an obtained calcined silver film was measured by a four-terminal method (Loresta GP MCP-T610). The measuring limit of this device is 10⁷ Ωcm.

Reagents used in Examples and Comparative Example are as follows:
n-Butylamine (MW: 73.14): reagent manufactured by Tokyo Chemical Industry Co., Ltd.;
2-Ethylhexylamine (MW: 129.25): reagent manufactured by Wako Pure Chemical Industries, Ltd.;
n-Octylamine (MW: 129.25): reagent manufactured by Tokyo Chemical Industry Co., Ltd.;
Methanol: special grade reagent manufactured by Wako Pure Chemical Industries, Ltd.;
1-Butanol: special grade reagent manufactured by Wako Pure Chemical Industries, Ltd.;
Silver oxalate (MW: 303.78): synthesized from silver nitrate (manufactured by Wako Pure Chemical Industries, Ltd.) and
oxalic acid dihydrate (manufactured by Wako Pure Chemical Industries, Ltd.).

### [Example 1]

### (Preparation of silver nano-particles)

In a 500-mL flask, 40.0 g (0.1317 mol) of silver oxalate was charged, and then 60 g of n-butanol was added thereto to prepare a n-butanol slurry of silver oxalate. An amine mixture liquid of 115.58 g (1.5802 mol) of n-butylamine, 51.06 g (0.3950 mol) of 2-ethylhexylamine, and 17.02 g (0.1317 mol) of n-octylamine was dropped into this slurry at 30°C. After the dropping, the slurry was stirred at 30°C for 1 hour to allow a complex forming reaction between silver oxalate and the amines to proceed. After a silver oxalate-amine complex was formed, the silver oxalate-amine complex was thermally decomposed by heating at 110°C to obtain a suspension in which deep blue silver nano-particles were suspended in the amine mixture liquid.

The obtained suspension was cooled, and 120 g of methanol was added thereto with stirring, and then the silver nano-particles were spun down by centrifugation to remove a supernatant. Then, 120 g of diethylene glycol monobutyl ether (manufactured by Tokyo Chemical Industry Co., Ltd.) was added to the silver nano-particles with stirring, and then the silver nano-particles were spun down by centrifugation to remove a supernatant. In this way, wet silver nano-particles containing diethylene glycol monobutyl ether were obtained. As a result of thermobalance using TG/DTA6300 manufactured by SII, the amount of silver nano-particles occupying the wet silver nano-particles was 90 wt%.

Further, the wet silver nano-particles were observed by a standard method using a scanning electron microscope (JSM-6700F manufactured by JEOL Ltd.) to determine the average particle diameter of the silver nano-particles. As a result, the average particle diameter (primary particle diameter) of the silver nano-particles was about 50 nm.

The average particle diameter was determined in the following manner. The silver nano-particles were observed with SEM. The particle diameters of 10 of the silver particles arbitrarily selected on a SEM photograph were determined, and their average was regarded as the average particle diameter of the silver nano-particles.

### (Preparation of silver ink)

First, 1.2 g of di[1-ethyl-(3-oxetanyl)]methyl ether (OXT-221 manufactured by TOAGOSEI CO., LTD.) as a bifunctional oxetane monomer, 0.9 g of a polyvinyl butyral resin (S-LEC B, type: BM-1, manufactured by SEKISUI CHEMICAL CO., LTD.), 0.3 g of polycaprolactone triol (PCL305 manufactured by Daicel Corporation), 0.3 g of a cationic polymerization initiator SI-100L (manufactured by SANSHIN CHEMICAL INDUSTRY CO., LTD.), and 6.3 g of diethylene glycol monobutyl ether acetate (manufactured by Daicel Corporation) were mixed to completely dissolve the polyvinyl butyral resin.

Then, 6 g of the obtained solution was weighed. Then, 10 g of the wet silver nano-particles containing diethylene glycol monobutyl ether was weighed. Then, 6 g of the obtained solution, 10 g of the wet silver nano-particles, and 4 g of flaky silver microparticles (Silbest Series, type: TC-507A, manufactured by TOKURIKI HONTEN CO., LTD.) were kneaded with stirring by a planetary centrifugal kneader (MAZERUSTAR KKK2508 manufactured by KURABO INDUSTRIES LTD.) for 30 seconds to obtain a mixture. Then, the mixture was further stirred by the kneader for 30 seconds and then stirred with a spatula for 1 minute, which was repeated twice. In this way, a blackish brown silver ink was prepared.

The obtained silver ink was subjected to TG-DTA (thermo gravimetric-differential thermal analysis) using TG/DTA 6300 manufactured by SII to determine the silver concentration of the silver ink. As a result, the silver concentration was 65 wt%. Further, the viscosity of the silver ink was measured using a rheometer (Rheometer MCR301 manufactured by Anton Paar) . As a result, the viscosities of the silver ink at different shear rates (/s) were 22 Pa·s (5/s), 12 Pa·s (10/s), and 5 Pa·s (50/s).

Table 1 shows the composition of the silver ink. In Table 1, the amount of each of the components is expressed in part(s) by weight per 100 parts by weight of the total amount of the silver ink. As described above, "the amount of silver nano-particles occupying the wet silver nano-particles was 90 wt%", and therefore,
"wet silver nano-particles: 10g" = "silver nano-particles themselves: 9g" + "diethylene glycol monobutyl ether: 1 g". Based on this, Table 1 shows that "the amount of the silver nano-particles themselves" is "45 parts by weight", and "the amount of diethylene glycol monobutyl ether" is "5 parts by weight".

### (Printability of silver ink)

The silver ink was printed on a PEN film by a gravure offset printing apparatus having a silicone blanket (MINI Lab FINE II manufactured by JEOL Ltd.) to evaluate printability. As a result, it was confirmed by CCD observation that fine lines of L/S = 30 µm/30 µm could be transferred. The residual ink was not visually observed on the blanket.

### (Adhesion to substrate)

The silver ink was applied onto an ITO film and dried at 120°C for 30 minutes to form a coating film having a thickness of 5 µm. The obtained coating film was subjected to a cross-cut tape peeling test (25 squares) using a cellophane adhesive tape (manufactured by Nichiban Co., Ltd.) in accordance with JIS K5600. The coating film exhibited "excellent" adhesion.
Excellent: No peeing occurred (0/25).
Poor: Peeling occurred (1/25 or more).

### (Calcining of silver ink)

The silver ink was applied onto a soda glass plate to form a coating film. After being formed, the coating film was rapidly calcined in a fan drying oven at 120°C for 30 minutes to form a calcined silver film having a thickness of 10 µm. The specific resistance value of the obtained calcined silver film was measured by a four-terminal method, and as a result, the calcined silver film exhibited excellent conductivity of 14.0 µΩcm. Thus, the silver ink exhibited excellent conductivity by low-temperature and short-time calcining.

### [Example 2]

Silver nano-particles were prepared in the same manner as in Example 1.

### (Preparation of silver ink)

First, 0.9 g of a bifunctional oxetane monomer (OXT-221 manufactured by TOAGOSEI CO., LTD.), 0.6 g of a polyvinyl butyral resin (S-LEC B, type: BM-1, manufactured by SEKISUI CHEMICAL CO., LTD.), 0.3 g of polycaprolactone triol (PCL305 manufactured by Daicel Corporation), 0.3 g of a cationic polymerization initiator SI-100L (manufactured by SANSHIN CHEMICAL INDUSTRY CO., LTD.), and 6.9 g of diethylene glycol monobutyl ether acetate (manufactured by Daicel Corporation) were mixed to completely dissolve the polyvinyl butyral resin.

Then, 6 g of the obtained solution was weighed. Then, 10 g of the wet silver nano-particles containing diethylene glycol monobutyl ether was weighed. Then, 6 g of the obtained solution, 10 g of the wet silver nano-particles, and 4 g of flaky silver microparticles (Silbest Series, type: TC-507A, manufactured by TOKURIKI HONTEN CO., LTD.) were kneaded with stirring by a planetary centrifugal kneader (MAZERUSTAR KKK2508 manufactured by KURABO INDUSTRIES LTD.) in the same manner as in Example 1 to prepare a blackish brown silver ink.

The silver concentration of the silver ink was 65 wt%.

The viscosities of the silver ink were 22 Pa·s (5/s), 11 Pa·s (10/s), and 5 Pa·s (50/s).

### (Printability of silver ink)

The silver ink was printed on a PEN film by a gravure offset printing apparatus having a silicone blanket (MINI Lab FINE II manufactured by JEOL Ltd.) to evaluate printability. As a result, it was confirmed by CCD observation that fine lines of L/S = 30 µm/30 µm could be transferred. The residual ink was not visually observed on the blanket.

### (Adhesion to substrate)

A coating film having a thickness of 5 µm was formed on an ITO film using the silver ink in the same manner as in Example 1. The obtained coating film was subjected to a cross-cut tape peeling test (25 squares). The coating film exhibited "excellent" adhesion.

### (Calcining of silver ink)

A calcined silver film having a thickness of 10 µm was formed on a soda glass plate using the silver ink in the same manner as in Example 1. The specific resistance value of the obtained calcined silver film was measured by a four-terminal method, and as a result, the calcined silver film exhibited excellent conductivity of 12.0 µΩcm. Thus, the silver ink exhibited excellent conductivity by low-temperature and short-time calcining.

### [Example 3]

Silver nano-particles were prepared in the same manner as in Example 1.

### (Preparation of silver ink)

First, 0.9 g of a bifunctional oxetane monomer (OXT-221 manufactured by TOAGOSEI CO., LTD.), 0.6 g of a polyvinyl butyral resin (S-LEC B, type: BM-1, manufactured by SEKISUI CHEMICAL CO., LTD.), 0.3 g of polycaprolactone triol (PCL305 manufactured by Daicel Corporation), 0.3 g of a cationic polymerization initiator SI-100L (manufactured by SANSHIN CHEMICAL INDUSTRY CO., LTD.), and 6.9 g of diethylene glycol monobutyl ether acetate (manufactured by Daicel Corporation) were mixed to completely dissolve the polyvinyl butyral resin.

Then, 6.2 g of the obtained solution was weighed. Then, 8 g of the wet silver nano-particles containing diethylene glycol monobutyl ether was weighed. Then, 6.2 g of the obtained solution, 8 g of the wet silver nano-particles, and 5.8 g of flaky silver microparticles (Silbest Series, type: TC-507A, manufactured by TOKURIKI HONTEN CO., LTD.) were kneaded with stirring by a planetary centrifugal kneader (MAZERUSTAR KKK2508 manufactured by KURABO INDUSTRIES LTD.) in the same manner as in Example 1 to prepare a blackish brown silver ink.

The silver concentration of the silver ink was 65 wt%.

The viscosities of the silver ink were 21 Pa·s (5/s), 12 Pa·s (10/s), and 5 Pa·s (50/s).

### (Printability of silver ink)

The silver ink was printed on a PEN film by a gravure offset printing apparatus having a silicone blanket (MINI Lab FINE II manufactured by JEOL Ltd.) to evaluate printability. As a result, it was confirmed by CCD observation that fine lines of L/S = 30 µm/30 µm could be transferred. The residual ink was not visually observed on the blanket.

### (Adhesion to substrate)

A coating film having a thickness of 5 µm was formed on an ITO film using the silver ink in the same manner as in Example 1. The obtained coating film was subjected to a cross-cut tape peeling test (25 squares). The coating film exhibited "excellent" adhesion.

### (Calcining of silver ink)

A calcined silver film having a thickness of 10 µm was formed on a soda glass plate using the silver ink in the same manner as in Example 1. The specific resistance value of the obtained calcined silver film was measured by a four-terminal method, and as a result, the calcined silver film exhibited excellent conductivity of 28.0 µΩcm. Thus, the silver ink exhibited excellent conductivity by low-temperature and short-time calcining.

### [Comparative Example 1: Without silver nano-particles]

### (Preparation of silver ink)

First, 1.2 g of a bifunctional oxetane monomer (OXT-221 manufactured by TOAGOSEI CO., LTD.), 0.9 g of a polyvinyl butyral resin (S-LEC B, type: BM-1, manufactured by SEKISUI CHEMICAL CO., LTD.), 0.3 g of polycaprolactone triol (PCL305 manufactured by Daicel Corporation), 0.3 g of a cationic polymerization initiator SI-100L (manufactured by SANSHIN CHEMICAL INDUSTRY CO., LTD.), 1.5 g of diethylene glycol monobutyl ether (manufactured by Tokyo Chemical Industries Co. , Ltd.), and 6.3 g of diethylene glycol monobutyl ether acetate (manufactured by Daicel Corporation) were mixed to completely dissolve the polyvinyl butyral resin.

Then, 7 g of the obtained solution was weighed. Then, 7 g of the obtained solution and 13 g of flaky silver microparticles (Silbest Series, type: TC-507A, manufactured by TOKURIKI HONTEN CO., LTD.) were kneaded with stirring by a planetary centrifugal kneader (MAZERUSTAR KKK2508 manufactured by KURABO INDUSTRIES LTD.) in the same manner as in Example 1 to prepare a blackish brown silver ink.

The silver concentration of the silver ink was 65 wt%.

The viscosities of the silver ink were 21 Pa·s (5/s), 12 Pa·s (10/s), and 5 Pa·s (50/s).

### (Printability of silver ink)

The silver ink was printed on a PEN film by a gravure offset printing apparatus having a silicone blanket (MINI Lab FINE II manufactured by JEOL Ltd.) to evaluate printability. As a result, it was confirmed by CCD observation that fine lines of L/S - 30 µm/30 µm could be transferred. The residual ink was not visually observed on the blanket.

### (Adhesion to substrate)

A coating film having a thickness of 5 µm was formed on an ITO film using the silver ink in the same manner as in Example 1. The obtained coating film was subjected to a cross-cut tape peeling test (25 squares). The coating film exhibited "excellent" adhesion.

### (Calcining of silver ink)

A calcined silver film having a thickness of 10 µm was formed on a soda glass plate using the silver ink in the same manner as in Example 1. The specific resistance value of the obtained calcined silver film was measured by a four-terminal method, and as a result, the calcined silver film exhibited poor conductivity of 66.0 µΩcm. Thus, the silver ink exhibited poor conductivity by low-temperature and short-time calcining.

### [Comparative Example 2: Without silver nano-particles]

### (Preparation of silver ink)

First, 0.9 g of a bifunctional oxetane monomer (OXT-221 manufactured by TOAGOSEI CO., LTD.), 0.6 g of a polyvinyl butyral resin (S-LEC B, type: BM-1, manufactured by SEKISUI CHEMICAL CO., LTD.), 0.3 g of polycaprolactone triol (PCL305 manufactured by Daicel Corporation), 0.3 g of a cationic polymerization initiator SI-100L (manufactured by SANSHIN CHEMICAL INDUSTRY CO., LTD.), 1.5 g of diethylene glycol monobutyl ether (manufactured by Tokyo Chemical Industries Co., Ltd.), and 6.9 g of diethylene glycol monobutyl ether acetate (manufactured by Daicel Corporation) were mixed to completely dissolve the polyvinyl butyral resin.

Then, 7 g of the obtained solution was weighed. Then, 7 g of the obtained solution and 13 g of flaky silver microparticles (Silbest Series, type: TC-507A, manufactured by TOKURIKI HONTEN CO., LTD.) were kneaded with stirring by a planetary centrifugal kneader (MAZERUSTAR KKK2508 manufactured by KURABO INDUSTRIES LTD.) in the same manner as in Example 1 to prepare a blackish brown silver ink.

The silver concentration of the silver ink was 65 wt%.

The viscosities of the silver ink were 20 Pa·s (5/s), 11 Pa·s (10/s), and 5 Pa·s (50/s).

### (Printability of silver ink)

The silver ink was printed on a PEN film by a gravure offset printing apparatus having a silicone blanket (MINI Lab FINE II manufactured by JEOL Ltd.) to evaluate printability. As a result, it was confirmed by CCD observation that fine lines of L/S = 30 µm/30 µm could be transferred. The residual ink was not visually observed on the blanket.

### (Adhesion to substrate)

A coating film having a thickness of 5 µm was formed on an ITO film using the silver ink in the same manner as in Example 1. The obtained coating film was subjected to a cross-cut tape peeling test (25 squares). The coating film exhibited "excellent" adhesion.

### (Calcining of silver ink)

A calcined silver film having a thickness of 10 µm was formed on a soda glass plate using the silver ink in the same manner as in Example 1. The specific resistance value of the obtained calcined silver film was measured by a four-terminal method, and as a result, the calcined silver film exhibited poor conductivity of 60.0 µΩcm. Thus, the silver ink exhibited poor conductivity by low-temperature and short-time calcining.

Table 1 shows the above results.

**[Table 1]**

| | Components | Example 1 | Example 2 | Example 3 | Comparative Example 1 | Comparative Example 2 |
|---|---|---|---|---|---|---|
| Ink Composition (part(s) by weight) | Silver nano-particles | 45 | 45 | 36 | - | - |
| | Silver microparticles TC-507A | 20 | 20 | 29 | 65 | 65 |
| | Oxetane monomer OXT221 | 4 | 3 | 3 | 4 | 3 |
| | Polycaprolactone triol PCL305 | 1 | 1 | 1 | 1 | 1 |
| | Polyvinyl butyral resin BM-1 | 3 | 2 | 2 | 3 | 2 |
| | Cationic polymerization initiator SI-100L | 1 | 1 | 1 | 1 | 1 |
| | Diethylene glycol monobutyl ether BC | 5 | 5 | 5 | 5 | 5 |
| | Diethylene glycol monobutyl ether acetate BCA | 21 | 23 | 23 | 21 | 23 |
| Evaluation Results | Specific resistance value (µΩ·cm) | 14 | 12 | 28 | 66 | 60 |
| | Adhesion | Excellent | Excellent | Excellent | Excellent | Excellent |
| | Transferability | Excellent | Excellent | Excellent | Excellent | Excellent |

## Claims

1. A silver particle coating composition comprising:
silver nano-particles (N) whose surfaces are coated with a protective agent containing an aliphatic hydrocarbon amine;
silver microparticles (M); and
a dispersion solvent,
wherein the amount of the silver nano-particles (N) is 10 to 90 wt%, based on the total amount of the silver nano-particles (N) and the silver microparticles (M), and
wherein the total amount of the silver nano-particles (N) and the silver microparticles (M) is 10% by weight or more and 80% by weight or less in the silver particle coating composition.

2. The silver particle coating composition according to claim 1, wherein
the aliphatic hydrocarbon amine in the silver nano-particles (N) comprises an aliphatic hydrocarbon monoamine (A) comprising an aliphatic hydrocarbon group and one amino group, said aliphatic hydrocarbon group having 6 or more carbon atoms in total, and
further comprises at least one of: an aliphatic hydrocarbon monoamine (B) comprising an aliphatic hydrocarbon group and one amino group, said aliphatic hydrocarbon group having 5 or less carbon atoms in total; and an aliphatic hydrocarbon diamine (C) comprising an aliphatic hydrocarbon group and two amino groups, said aliphatic hydrocarbon group having 8 or less carbon atoms in total.

3. The silver particle coating composition according to claim 2, wherein the aliphatic hydrocarbon monoamine (A) is at least one selected from the group consisting of a linear alkylmonoamine having a linear alkyl group having 6 or more and 12 or less carbon atoms, and a branched alkylmonoamine having a branched alkyl group having 6 or more and 16 or less carbon atoms.

4. The silver particle coating composition according to claim 2 or 3, wherein the aliphatic hydrocarbon monoamine (B) is an alkylmonoamine having 2 or more and 5 or less carbon atoms.

5. The silver particle coating composition according to any one of claims 2 to 4, wherein the aliphatic hydrocarbon diamine (C) is an alkylenediamine in which one of the two amino groups is a primary amino group, and the other is a tertiary amino group.

6. The silver particle coating composition according to any one of claims 1 to 5, wherein the aliphatic hydrocarbon amine is used in a total amount of 1 to 50 moles per 1 mole of silver atoms in the silver nano-particles (N).

7. The silver particle coating composition according to any one of claims 1 to 6, further comprising a binder resin.

8. The silver particle coating composition according to claim 7, wherein the binder resin comprises at least one selected from the group consisting of a polyvinyl butyral resin, a polyester-based resin, an acrylic resin, an ethyl cellulose-based resin, a phenol-based resin, a polyimide-based resin, a melamine-based resin, and a melamine-polyester-based resin.

9. The silver particle coating composition according to any one of claims 1 to 8, further comprising a curable monomer and a polymerization initiator.

10. The silver particle coating composition according to claim 9, wherein the curable monomer comprises at least one selected from the group consisting of an oxetane compound and an epoxy compound.

11. The silver particle coating composition according to any one of claims 1 to 10, wherein the dispersion solvent comprises a glycol-based solvent, a glycol ester-based solvent, or a combination thereof.

12. Use of the silver particle coating composition according to any one of claims 1 to 11 for intaglio offset printing.

13. A method for producing an electronic device comprising: a substrate; and a silver conductive layer, the method comprising:
applying, onto the substrate, the silver particle coating composition according to any one of claims 1 to 11 to form a silver particle-containing coating layer, and then calcining the coating layer to form a silver conductive layer.

## Patentansprüche

1. Silberpartikelbeschichtungszusammensetzung, umfassend:
Silbernanopartikel (N), deren Oberflächen mit einem Schutzmittel beschichtet sind, das ein aliphatisches Kohlenwasserstoffamin enthält;
Silbermikropartikel (M) und
ein Dispersionslösungsmittel,
wobei die Menge der Silbernanopartikel (N) 10 bis 90 Gew.-% beträgt, bezogen auf die Gesamtmenge der Silbernanopartikel (N) und der Silbermikropartikel (M), und
wobei die Gesamtmenge der Silbernanopartikel (N) und der Silbermikropartikel (M) in der Silberpartikelbeschichtungszusammensetzung 10 Gew.-% oder mehr und 80 Gew.-% oder weniger beträgt.

2. Silberpartikelbeschichtungszusammensetzung gemäß Anspruch 1, wobei
das aliphatische Kohlenwasserstoffamin in den Silbernanopartikeln (N) ein aliphatisches Kohlenwasserstoffmonoamin (A) umfasst, das eine aliphatische Kohlenwasserstoffgruppe und eine Aminogruppe umfasst, wobei die aliphatische Kohlenwasserstoffgruppe 6 insgesamt 6 oder mehr Kohlenstoffatome aufweist, und
ferner mindestens eines umfasst aus: einem aliphatischen Kohlenwasserstoffmonoamin (B), das eine aliphatische Kohlenwasserstoffgruppe und eine Aminogruppe umfasst, wobei die aliphatische Kohlenwasserstoffgruppe insgesamt 5 oder weniger Kohlenstoffatome aufweist, und einem aliphatischen Kohlenwasserstoffdiamin (C), das eine aliphatische Kohlenwasserstoffgruppe und zwei Aminogruppen umfasst, wobei die aliphatische Kohlenwasserstoffgruppe insgesamt 8 oder weniger Kohlenstoffatome aufweist.

3. Silberpartikelbeschichtungszusammensetzung gemäß Anspruch 2, wobei es sich bei dem aliphatischen Kohlenwasserstoffmonoamin (A) um mindestens eines handelt, ausgewählt aus der Gruppe, bestehend aus einem linearen Alkylmonoamin mit einer linearen Alkylgruppe mit 6 oder mehr und 12 oder weniger Kohlenstoffatomen und einem verzweigten Alkylmonoamin mit einer verzweigten Alkylgruppe mit 6 oder mehr und 16 oder weniger Kohlenstoffatomen.

4. Silberpartikelbeschichtungszusammensetzung gemäß Anspruch 2 oder 3, wobei es sich bei dem aliphatischen Kohlenwasserstoffmonoamin (B) um ein Alkylmonoamin mit 2 oder mehr und 5 oder weniger Kohlenstoffatomen handelt.

5. Silberpartikelbeschichtungszusammensetzung gemäß einem der Ansprüche 2 bis 4, wobei es sich bei dem aliphatischen Kohlenwasserstoffdiamin (C) um ein Alkylendiamin handelt, in dem eine der beiden Aminogruppen eine primäre Aminogruppe ist und die andere eine tertiäre Aminogruppe ist.

6. Silberpartikelbeschichtungszusammensetzung gemäß einem der Ansprüche 1 bis 5, wobei das aliphatische Kohlenwasserstoffamin in einer Gesamtmenge von 1 bis 50 Mol pro 1 Mol Silberatome in den Silbernanopartikeln (N) verwendet wird.

7. Silberpartikelbeschichtungszusammensetzung gemäß einem der Ansprüche 1 bis 6, ferner umfassend ein Bindemittelharz.

8. Silberpartikelbeschichtungszusammensetzung gemäß Anspruch 7, wobei das Bindemittelharz mindestens eines umfasst, ausgewählt aus der Gruppe, bestehend aus einem Polyvinylbutyralharz, einem Harz auf Polyesterbasis, einem Acrylharz, einem Harz auf Ethylcellulosebasis, einem Harz auf Phenolbasis, einem Harz auf Polyimidbasis, einem Harz auf Melaminbasis und einem Harz auf Melamin-Polyester-Basis.

9. Silberpartikelbeschichtungszusammensetzung gemäß einem der Ansprüche 1 bis 8, ferner umfassend ein härtbares Monomer und einen Polymerisationsinitiator.

10. Silberpartikelbeschichtungszusammensetzung gemäß Anspruch 9, wobei das härtbare Monomer mindestens eines umfasst, ausgewählt aus der Gruppe, bestehend aus einer Oxetanverbindung und einer Epoxyverbindung.

11. Silberpartikelbeschichtungszusammensetzung gemäß einem der Ansprüche 1 bis 10, wobei das Dispersionslösungsmittel ein Lösungsmittel auf Glykolbasis, ein Lösungsmittel auf Glykolesterbasis oder eine Kombination davon umfasst.

12. Verwendung der Silberpartikelbeschichtungszusammensetzung gemäß einem der Ansprüche 1 bis 11 für den Tiefdruck-Offsetdruck.

13. Verfahren zum Herstellen einer elektronischen Vorrichtung, umfassend: ein Substrat und eine leitfähige Silberschicht, wobei das Verfahren umfasst:
Auftragen der Silberpartikelbeschichtungszusammensetzung gemäß einem der Ansprüche 1 bis 11 auf das Substrat, um eine Silberpartikel enthaltende Beschichtungsschicht zu bilden, und dann Kalzinieren der Beschichtungsschicht, um eine leitende Silberschicht zu bilden.

## Revendications

1. Composition de revêtement aux particules d'argent comprenant :
des nanoparticules d'argent (N) dont les surfaces sont revêtues d'un agent protecteur contenant un hydrocarbure aliphatique aminé ;
des microparticules d'argent (M) ; et
un solvant de dispersion,
la quantité des nanoparticules d'argent (N) allant de 10 à 90 % en poids, sur la base de la quantité totale des nanoparticules d'argent (N) et des microparticules d'argent (M), et
la quantité totale des nanoparticules d'argent (N) et des microparticules d'argent (M) représentant 10 % en poids ou plus et 80 % en poids ou moins de la composition de revêtement aux particules d'argent.

2. Composition de revêtement aux particules d'argent selon la revendication 1, dans laquelle
l'hydrocarbure aliphatique amine dans les nanoparticules d'argent (N) comprend un hydrocarbure aliphatique monoamine (A) comprenant un groupe hydrocarbure aliphatique et un groupe amino, ledit groupe hydrocarbure aliphatique ayant 6 atomes de carbone ou plus au total, et
comprend en outre l'un au moins parmi : un hydrocarbure aliphatique monoamine (B) comprenant un groupe hydrocarbure aliphatique et un groupe amino, ledit groupe hydrocarbure aliphatique ayant 5 atomes de carbone ou moins au total ; et un hydrocarbure aliphatique diamine (C) comprenant un groupe hydrocarbure aliphatique et deux groupes amino, ledit groupe hydrocarbure aliphatique ayant 8 atomes de carbone ou moins au total.

3. Composition de revêtement aux particules d'argent selon la revendication 2, dans laquelle l'hydrocarbure aliphatique monoamine (A) est une combinaison d'une alkylmonoamine linéaire ayant un groupe alkyle linéaire ayant au moins 6 et au plus 12 atomes de carbone, et d'une alkylmonoamine ramifiée ayant un groupe alkyle ramifié ayant au moins 6 et au plus 16 atomes de carbone.

4. Composition de revêtement aux particules d'argent selon la revendication 2 ou 3, l'hydrocarbure aliphatique monoamine (B) étant une alkylmonoamine ayant au moins 2 et au plus 5 atomes de carbone.

5. Composition de revêtement aux particules d'argent selon l'une quelconque des revendications 2 à 4, dans laquelle l'hydrocarbure aliphatique diamine (C) est une alkylènediamine dans laquelle l'un des deux groupes amino est un groupe amino primaire, et l'autre est un groupe amino tertiaire.

6. Composition de revêtement aux particules d'argent selon l'une quelconque des revendications 1 à 5, dans laquelle l'hydrocarbure aliphatique amine est employé en quantité totale de 1 à 50 moles pour 1 mole d'atomes d'argent dans les nanoparticules d'argent (N).

7. Composition de revêtement aux particules d'argent selon l'une quelconque des revendications 1 à 6, comprenant, en outre, une résine liante.

8. Composition de revêtement aux particules d'argent selon la revendication 7, dans laquelle la résine liante comprend au moins une résine choisie dans la groupe constitué par une résine de poly(butyral de vinyle), une résine à base de polyester, une résine acrylique, une résine à base d'éthylcellulose, une résine à base de phénol, une résine à base de polyimide, une résine à base de mélamine et une résine à base de mélamine-polyester.

9. Composition de revêtement aux particules d'argent selon l'une quelconque des revendications 1 à 8, comprenant, en outre, un monomère durcissable et un initiateur de polymérisation.

10. Composition de revêtement aux particules d'argent selon la revendication 9, dans laquelle le monomère durcissable comprend au moins un monomère choisi dans le groupe constitué par un composé oxétane et un composé époxy.

11. Composition de revêtement aux particules d'argent selon l'une quelconque des revendications 1 à 10, dans laquelle le solvant de dispersion comprend un solvant à base de glycol, un solvant à base d'ester de glycol, ou une combinaison de ceux-ci.

12. Utilisation de la composition de revêtement aux particules d'argent selon l'une quelconque des revendications 1 à 11, pour de l'impression offset en creux.

13. Procédé de production d'un dispositif électronique comprenant : un substrat et une couche conductrice à l'argent, le procédé comprenant :
l'application, sur le substrat, de la composition de revêtement aux particules d'argent selon l'une quelconque des revendications 1 à 11 pour former une couche de revêtement contenant des particules d'argent, et, ensuite, la calcination de la couche de revêtement pour former une couche conductrice à l'argent.
